# EUROPEAN PATENT APPLICATION

(11) **EP 4 383 583 A1**
(43) Date of publication of application: **12.06.2024**
(21) Application number: 22852935.0
(22) Date of filing: 28.07.2022
(51) Int. Cl.: H04B 7/0417, G06N 3/04, G06N 3/08, H03M 7/30, H04W 28/18

(54) **COMMUNICATION SYSTEM**

(30) Priority: 03.08.2021 JP 2021127564
(71) Applicant: MITSUBISHI ELECTRIC CORPORATION, Chiyoda-ku Tokyo 100-8310 (JP)
(72) Inventor: SHIMODA, Tadahiro, Tokyo 100-8310 (JP); MOCHIZUKI, Mitsuru, Tokyo 100-8310 (JP); IWAYAMA, Naofumi, Tokyo 100-8310 (JP); TOKUDA, Tatsuya, Tokyo 100-8310 (JP)
(74) Representative: Meissner Bolte Partnerschaft mbB
(86) International application number: PCT/JP2022/029064
(87) International publication number: WO 2023/013512

(57) **Abstract**

A communication system includes: a communication terminal that encodes transmission data by using an encoding model that encodes and outputs data that has been input; and a base station that decodes data encoded with the encoding model by using a decoding model that, when encoded data is input, decodes and outputs the data, the encoding model performs encoding on channel state-related data that is data on a channel state between the communication terminal and the base station, and the base station executes machine learning using learning data including the channel state-related data in an un-encoded state to generate the encoding model and the decoding model, and notifies the communication terminal of a learning result of the encoding model.

## Description

### Field

The present disclosure relates to a radio communication technology.

### Background

The 3rd Generation Partnership Project (3GPP), which is a standard organization of mobile communication systems, has been studying a communication system called long term evolution (LTE) for radio sections and called system architecture evolution (SAE) for an entire system configuration including a core network and a radio access network (hereinafter, also collectively referred to as a network) (for example, Non Patent Literatures 1 to 5). The communication system is also referred to as a 3.9 generation (3.9 G) system.

As an access scheme of LTE, orthogonal frequency division multiplexing (OFDM) is used in a downlink direction, and single carrier frequency division multiple access (SC-FDMA) is used in an uplink direction. In addition, unlike wideband code division multiple access (W-CDMA), LTE does not provide circuit switching and provides only a packet communication system.

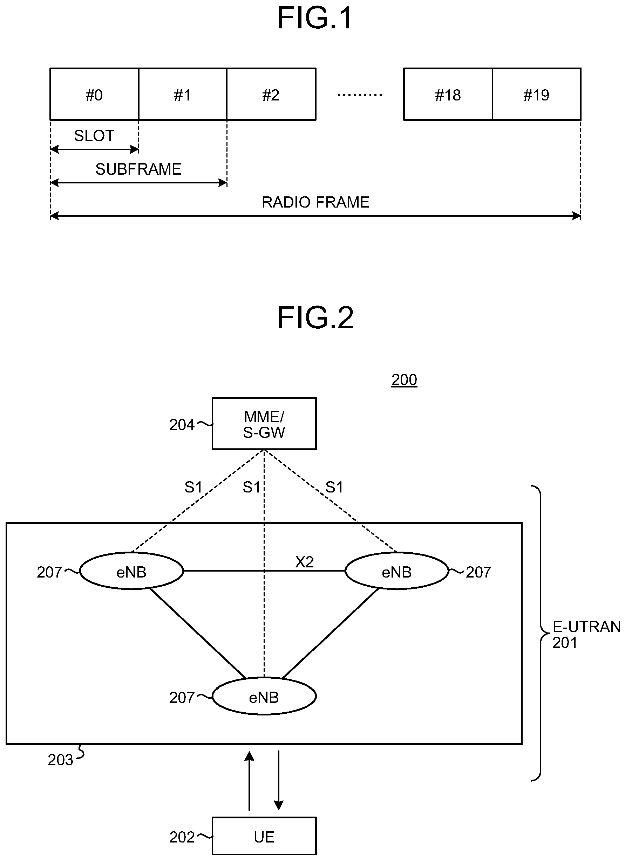

Decisions by 3GPP regarding a frame configuration in an LTE system described in Non Patent Literature 1 (Chapter 5) will be described with reference to FIG. 1. FIG. 1 is an explanatory diagram illustrating a configuration of a radio frame used in an LTE communication system. In FIG. 1, one radio frame is 10 ms. The radio frame is divided into 10 equally sized subframes. The subframe is divided into two equally sized slots. Downlink synchronization signals are included in first and sixth subframes in each radio frame. The synchronization signals are classified into a primary synchronization signal (P-SS) and a secondary synchronization signal (S-SS).

Decisions by 3GPP regarding a channel configuration in the LTE system are described in Non Patent Literature 1 (Chapter 5). It is assumed that also in a closed subscriber group (CSG) cell, the same channel configuration as that of a non-CSG cell is used.

A physical broadcast channel (PBCH) is a channel for downlink transmission from a base station device (hereinafter, sometimes simply referred to as a "base station") to a communication terminal device (hereinafter, sometimes simply referred to as a "communication terminal") such as a user equipment device (hereinafter, sometimes simply referred to as "user equipment"). A BCH transport block is mapped to four subframes in a 40-ms interval. There is no explicit signaling of 40-ms timing.

A physical control format indicator channel (PCFICH) is a channel for downlink transmission from a base station to a communication terminal. The PCFICH notifies the number of orthogonal frequency division multiplexing (OFDM) symbols used for PDCCHs from the base station to the communication terminal. The PCFICH is transmitted on a per subframe basis.

A physical downlink control channel (PDCCH) is a channel for downlink transmission from a base station to a communication terminal. The PDCCH provides resource allocation information of a downlink shared channel (DL-SCH) which is one of transport channels to be described later, resource allocation information of a paging channel

(PCH) which is one of the transport channels to be described later, and hybrid automatic repeat request (HARQ) information about the DL-SCH. The PDCCH carries an uplink scheduling grant. The PDCCH carries acknowledgement (Ack)/negative acknowledgement (Nack) which is a response signal to uplink transmission. The PDCCH is also referred to as an L1/L2 control signal.

A physical downlink shared channel (PDSCH) is a channel for downlink transmission from a base station to a communication terminal. The downlink shared channel (DL-SCH) which is a transport channel and the PCH which is a transport channel are mapped to the PDSCH.

A physical multicast channel (PMCH) is a channel for downlink transmission from a base station to a communication terminal. A multicast channel (MCH) which is a transport channel is mapped to the PMCH.

A physical uplink control channel (PUCCH) is a channel for uplink transmission from a communication terminal to a base station. The PUCCH carries Ack/Nack which is a response signal to downlink transmission. The PUCCH carries channel state information (CSI). The CSI includes a rank indicator (RI), a precoding matrix indicator (PMI), and a channel quality indicator (CQI) report. The RI is rank information of a channel matrix in MIMO. The PMI is information on a precoding weight matrix used in MIMO. The CQI is quality information indicating quality of received data or channel quality. In addition, the PUCCH carries a scheduling request (SR).

A physical uplink shared channel (PUSCH) is a channel for uplink transmission from a communication terminal to a base station. An uplink shared channel (UL-SCH) which is one of the transport channels is mapped to the PUSCH.

A physical hybrid ARQ (HARQ) indicator channel (PHICH) is a channel for downlink transmission from a base station to a communication terminal. The PHICH carries Ack/Nack which is a response signal to uplink transmission. A physical random access channel (PRACH) is a channel for uplink transmission from a communication terminal to a base station. The PRACH carries a random access preamble.

A downlink reference signal (RS) is a symbol known in the LTE communication system. The following five types of downlink reference signals are defined. The signals are cell-specific reference signal (CRS), an MBSFN reference signal, a data demodulation reference signal (DM-RS) which is a UE-specific reference signal, a positioning reference signal (PRS), and a channel state information reference signal (CSI-RS). As a measurement of a physical layer of a communication terminal, there is a measurement of reference signal received power (RSRP).

Similarly, an uplink reference signal is a symbol known in the LTE communication system. The following two types of uplink reference signals are defined. The signals are a data demodulation reference signal (DMRS) and a sounding reference signal (SRS).

Transport channels described in Non Patent Literature 1 (Chapter 5) will be described. Among downlink transport channels, a broadcast channel (BCH) is broadcast in the entire coverage area of the base station (cell). The BCH is mapped to the physical broadcast channel (PBCH).

Retransmission control by hybrid ARQ (HARQ) is applied to the downlink shared channel (DL-SCH). The DL-SCH can be broadcast in the entire coverage area of the base station (cell). The DL-SCH supports dynamic or semi-static resource allocation. The semi-static resource allocation is also referred to as persistent scheduling. The DL-SCH supports discontinuous reception (DRX) of a communication terminal in order to reduce power consumption of the communication terminal. The DL-SCH is mapped to the physical downlink shared channel (PDSCH).

The paging channel (PCH) supports DRX of a communication terminal in order to enable the communication terminal to reduce power consumption. The PCH is required to be broadcast in the entire coverage area of the base station (cell). The PCH is mapped to a physical resource such as the physical downlink shared channel (PDSCH) that can be dynamically used for traffic.

A multicast channel (MCH) is used for broadcast in the entire coverage area of the base station (cell). The MCH supports SFN combining of multimedia broadcast multicast service (MBMS) services (MTCH and MCCH) in multi-cell transmission. The MCH supports semi-static resource allocation. The MCH is mapped to the PMCH.

Retransmission control by hybrid ARQ (HARQ) is applied to the uplink shared channel (UL-SCH) among the uplink transport channels. The UL-SCH supports dynamic or semi-static resource allocation. The UL-SCH is mapped to the physical uplink shared channel (PUSCH).

A random access channel (RACH) is limited to control information. The RACH has a risk of collision. The RACH is mapped to the physical random access channel (PRACH).

The HARQ will be described. The HARQ is a technology for improving communication quality of a transmission path by a combination of automatic repeat request (ARQ) and error correction (forward error correction). The HARQ has an advantage that error correction effectively functions by retransmission even for a transmission path whose communication quality changes. In particular, it is also possible to further improve the quality in retransmission by combining a reception result of first transmission and a reception result of the retransmission.

An example of a retransmission method will be described. In a case where a receiver cannot correctly decode received data, in other words, in a case where a cyclic redundancy check (CRC) error occurs (CRC=NG), "Nack" is transmitted from the receiver to a transmitter. The transmitter that has received "Nack" retransmits the data. In a case where the receiver can correctly decode received data, in other words, in a case where a CRC error does not occur (CRC=OK), "Ack" is transmitted from the receiver to the transmitter. The transmitter that has received "Ack" transmits next data.

A logical channel described in Non Patent Literature 1 (Chapter 6) will be described. A broadcast control channel (BCCH) is a downlink channel for broadcast system control information. The BCCH which is a logical channel is mapped to the broadcast channel (BCH) or the downlink shared channel (DL-SCH) each of which is a transport channel.

A paging control channel (PCCH) is a downlink channel for transmitting changes in paging information and system information. The PCCH is used in a case when the network does not know the cell location of a communication terminal. The PCCH which is a logical channel is mapped to the paging channel (PCH) which is a transport channel.

A common control channel (CCCH) is a channel for transmission control information between a communication terminal and a base station. The CCCH is used in a case where the communication terminal has no RRC connection with the network. In the downlink direction, the CCCH is mapped to the downlink shared channel (DL-SCH) which is a transport channel. In the uplink direction, the CCCH is mapped to the uplink shared channel (UL-SCH) which is a transport channel.

A multicast control channel (MCCH) is a downlink channel for point-to-multipoint transmission. The MCCH is used for transmission of MBMS control information for one or several MTCHs from the network to a communication terminal. The MCCH is used only by a communication terminal that is receiving the MBMS. The MCCH is mapped to the multicast channel (MCH) which is a transport channel.

A dedicated control channel (DCCH) is a channel for transmitting dedicated control information between a communication terminal and the network on a point-to-point basis. The DCCH is used in a case where the communication terminal has an RRC connection. The DCCH is mapped to the uplink shared channel (UL-SCH) in uplink, and is mapped to the downlink shared channel (DL-SCH) in downlink.

A dedicated traffic channel (DTCH) is a point-to-point communication channel for transmitting user information to a dedicated communication terminal. The DTCH exists in both uplink and downlink. The DTCH is mapped to the uplink shared channel (UL-SCH) in uplink, and is mapped to the downlink shared channel (DL-SCH) in downlink.

A multicast traffic channel (MTCH) is a downlink channel for transmitting traffic data from the network to a communication terminal. The MTCH is a channel used only by a communication terminal that is receiving the MBMS. The MTCH is mapped to the multicast channel (MCH).

CGI represents a cell global identifier. ECGI represents an E-UTRAN cell global identifier. A closed subscriber group (CSG) cell is introduced into LTE, long term evolution advanced (LTE-A) described later, and universal mobile telecommunication system (UMTS).

Location tracking of communication terminals is performed in units of areas each including one or more cells. The location tracking is performed in order to track the location of a communication terminal to call the communication terminal, in other words, in order to enable the communication terminal to receive an incoming call, even in an idle state. An area for the location tracking of communication terminals is referred to as a tracking area.

Furthermore, in 3GPP, as Release 10, formulation of long term evolution advanced (LTE-A) standard is in progress (see Non Patent Literatures 3 and 4). LTE-A is based on an LTE radio section communication system, and is configured by adding some new technologies to the system.

Regarding the LTE-A system, in order to support wider transmission bandwidths up to 100 MHz, carrier aggregation (CA) for aggregating two or more component carriers (CCs) is under study. The CA is described in Non Patent Literature 1.

In a case where the CA is configured, a UE which is a communication terminal has only one RRC connection with a network (NW). In the RRC connection, one serving cell provides NAS mobility information and security input. This cell is referred to as a primary cell (PCell). In downlink, a carrier corresponding to the PCell is a downlink primary component carrier (DL PCC). In uplink, a carrier corresponding to the PCell is an uplink primary component carrier (UL PCC).

Depending on the capability of the UE, a secondary cell (SCell) is configured to form a set of serving cells with the PCell. In downlink, a carrier corresponding to the SCell is a downlink secondary component carrier (DL SCC). In uplink, a carrier corresponding to the SCell is an uplink secondary component carrier (UL SCC).

A set of serving cells including one PCell and one or more SCells is configured for one UE.

In addition, new technologies in LTE-A include a technology for supporting wider bands (wider bandwidth extension), a coordinated multiple point transmission and reception (CoMP) technology. The CoMP studied for LTE-A in 3GPP is described in Non Patent Literature 1.

In addition, use of a small eNB (hereinafter, sometimes referred to as a "small-scale base station device") configuring a small cell has been studied in 3GPP in order to cope with enormous traffic in the future. For example, a technology is under study with which a large number of small eNBs are installed to configure a large number of small cells, thereby improving spectral efficiency to increase communication capacity. Specifically, there is dual connectivity (abbreviated as DC) with which a UE is connected to two eNBs to perform communication. The DC is described in Non Patent Literature 1.

One of the eNBs that perform dual connectivity (DC) may be referred to as a "master eNB (abbreviated as MeNB)", and the other thereof may be referred to as a "secondary eNB (abbreviated as SeNB)".

The traffic volume of a mobile network is on the increase, and the communication speed is also increasing. When operations of LTE and LTE-A are fully started, the communication speed is expected to be further increased.

Furthermore, for increasingly advanced mobile communication, a fifth generation (hereinafter, sometimes referred to as "5G") radio access system has been studied whose service is aimed to be launched in or after 2020. For example, in Europe, 5G requirements are compiled by an organization called METIS (see Non Patent Literature 5).

For the 5G radio access system, the followings are exemplified as requirements: as compared with the LTE system, the system capacity is 1000 times, the data transmission speed is 100 times, the data processing latency is one-tenth (1/10), the number of simultaneously connected communication terminals is 100 times, and further reduction in power consumption and reduction in device cost are achieved.

In order to satisfy such requirements, 5G standards have been studied as Release 15 in 3GPP (see Non Patent Literatures 6 to 19). The technology of 5G radio sections is referred to as "new radio access technology" ("new radio" is abbreviated as "NR").

An NR system has been studied on the basis of the LTE system and the LTE-A system, but includes additions and changes from the LTE system and the LTE-A system in the following points.

As an access scheme of NR, OFDM is used in the downlink direction, and OFDM and DFT-spread-OFDM (DFT-s-OFDM) are used in the uplink direction.

In NR, frequencies higher than those in LTE can be used to improve the transmission speed and to reduce the processing latency.

In NR, cell coverage is ensured by forming a narrow beam-shaped transmission/reception range (beamforming) and changing a direction of the beam (beam sweeping).

In a frame configuration of NR, various subcarrier spacings, that is, various numerologies, are supported. Regardless of the numerologies, one subframe is 1 millisecond long, and one slot includes 14 symbols in NR. In addition, the number of slots included in one subframe is one in a numerology with a subcarrier spacing of 15 kHz, and increases in proportion to subcarrier spacings in other numerologies (see Non Patent Literature 13 (3GPP TS38.211)).

A downlink synchronization signal in NR is transmitted as a synchronization signal burst (hereinafter, sometimes referred to as an SS burst) from a base station at a predetermined period for a predetermined duration. The SS burst includes a synchronization signal block (hereinafter, sometimes referred to as an SS block) for each beam of the base station.

The base station transmits the SS blocks of respective beams within the duration of the SS burst while changing the beams. The SS block includes the P-SS, the S-SS, and the PBCH.

In NR, a phase tracking reference signal (PTRS) is added as a downlink reference signal of NR, and thereby an influence of phase noise is reduced. Regarding an uplink reference signal as well, the PTRS is added similarly to the downlink.

In NR, a slot format indication (SFI) has been added to information included in the PDCCH in order to perform flexible switching between the DL and the UL in a slot.

Furthermore, in NR, the base station sets a part of a carrier frequency band (hereinafter, sometimes referred to as bandwidth part (BWP)) in advance for a UE, and the UE performs transmission and reception with the base station in the BWP, thereby reducing power consumption in the UE.

In 3GPP, as a form of the DC, DC performed by an LTE base station and an NR base station connected to an EPC, DC performed by NR base stations connected to a 5G core system, and DC performed by an LTE base station and an NR base station connected to the 5G core system have been studied (see Non Patent Literatures 12, 16, and 19).

In addition, in 3GPP, support of a service (which may be an application) using sidelink (SL) communication (also referred to as PC5 communication) in both an evolved packet system (EPS) to be described later and a 5G core system has been studied (see Non Patent Literatures 1, 16, 20, 21, 22, and 23). In the SL communication, communication is performed between terminals. Examples of the service using the SL communication include a vehicle-to-everything (V2X) service and a proximity service. In the SL communication, not only direct communication between terminals but also communication between a UE and an NW via a relay has been proposed (see Non Patent Literatures 20, 23, and 26) .

Furthermore, in 3GPP, integrated access and backhaul (IAB) has been studied in which both an access link which is a link between a UE and a base station and a backhaul link which is a link between base stations are performed by radio (see Non Patent Literatures 16 and 27).

In addition, several new technologies have been studied in 3GPP. For example, application of artificial intelligence (AI) and machine learning (ML) to PHY control of a RAN has been studied. Reduction in the number of transmission bits for a CSI report by encoding CSI using machine learning, improvement in beam quality by application of AI to beam control, reduction in communication overhead by optimization of a reference signal using AI, improvement in positioning performance by application of AI to positioning, and the like have been studied (see Non Patent Literatures 28 to 34).

### Citation List

### Non Patent Literature

Non Patent Literature 1: 3GPP TS 36.300 V16.5.0
Non Patent Literature 2: 3GPP S1-083461
Non Patent Literature 3: 3GPP TR 36.814 V9.2.0
Non Patent Literature 4: 3GPP TR 36.912 V16.0.0
Non Patent Literature 5: "Scenarios, requirements and KPIs for 5G mobile and wireless system", ICT-317669-METIS/D1.1
Non Patent Literature 6: 3GPP TR 23.799 V14.0.0
Non Patent Literature 7: 3GPP TR 38.801 V14.0.0
Non Patent Literature 8: 3GPP TR 38.802 V14.2.0
Non Patent Literature 9: 3GPP TR 38.804 V14.0.0
Non Patent Literature 10: 3GPP TR 38.912 V16.0.0
Non Patent Literature 11: 3GPP RP-172115
Non Patent Literature 12: 3GPP TS 37.340 V16.5.0
Non Patent Literature 13: 3GPP TS 38.211 V16.5.0
Non Patent Literature 14: 3GPP TS 38.213 V16.5.0
Non Patent Literature 15: 3GPP TS 38.214 V16.5.0
Non Patent Literature 16: 3GPP TS 38.300 V16.5.0
Non Patent Literature 17: 3GPP TS 38.321 V16.4.0
Non Patent Literature 18: 3GPP TS 38.212 V16.5.0
Non Patent Literature 19: 3GPP TS 38.331 V16.4.1
Non Patent Literature 20: 3GPP TR 23.703 V12.0.0
Non Patent Literature 21: 3GPP TS 23.501 V17.0.0
Non Patent Literature 22: 3GPP T S23.287 V16.5.0
Non Patent Literature 23: 3GPP TS 23.303 V16.0.0
Non Patent Literature 24: 3GPP TS 38.305 V16.4.0
Non Patent Literature 25: 3GPP TS 23.273 V17.0.0
Non Patent Literature 26: 3GPP TR 38.836 V17.0.0
Non Patent Literature 27: 3GPP TS 38.401 V16.5.0
Non Patent Literature 28: 3GPP TR 37.817 V0.1.0
Non Patent Literature 29: 3GPP RP-201620
Non Patent Literature 30: 3GPP RWS-210038
Non Patent Literature 31: 3GPP RWS-210185
Non Patent Literature 32: 3GPP RWS-210235
Non Patent Literature 33: 3GPP RWS-210260
Non Patent Literature 34: 3GPP RWS-210198
Non Patent Literature 35: 3GPP TS 37.320 V16.5.0

### Summary of Invention

### Problem to be solved by the Invention

It has been proposed that a 5G base station and a 5G UE have part or whole of an AI model, and thus CSI from the UE is encoded and fed back to the base station (See Non Patent Literatures 30 and 34). However, a subject that learns an encoding model and/or a decoding model is not disclosed. Therefore, there arises a problem in that encoding and decoding of a CSI report using the AI model cannot be realized.

In view of the above problem, an object of the present disclosure is to realize improvement in the efficiency of a communication system by enabling AI to be applied to encoding and decoding of data.

### Means to Solve the Problem

A communication system according to the present disclosure includes a communication terminal that encodes transmission data by using an encoding model that encodes and outputs data that has been input, and a base station that decodes data encoded with the encoding model by using a decoding model that, when encoded data is input, decodes and outputs the data. The encoding model performs encoding on channel state-related data that is data on a channel state between the communication terminal and the base station. The base station executes machine learning using learning data including the channel state-related data in an un-encoded state to generate the encoding model and the decoding model, and notifies the communication terminal of a learning result of the encoding model.

### Effects of the Invention

The present disclosure achieves an effect that it is possible to realize improvement in the efficiency of a communication system by enabling AI to be applied to encoding and decoding of data.

Objects, features, aspects, and advantages of the present disclosure will become more apparent from the following detailed description and the accompanying drawings.

### Brief Description of Drawings

FIG. 1 is an explanatory diagram illustrating a configuration of a radio frame used in an LTE communication system.
FIG. 2 is a block diagram illustrating an overall configuration of an LTE communication system 200 that has been discussed in 3GPP.
FIG. 3 is a block diagram illustrating an overall configuration of an NR communication system 210 that has been discussed in 3GPP.
FIG. 4 is a configuration diagram of DC performed by an eNB and a gNB connected to an EPC.
FIG. 5 is a configuration diagram of DC performed by gNBs connected to an NG core.
FIG. 6 is a configuration diagram of DC performed by an eNB and the gNB connected to the NG core.
FIG. 7 is a configuration diagram of DC performed by an eNB and the gNB connected to the NG core.
FIG. 8 is a block diagram illustrating a configuration of user equipment 202 illustrated in FIG. 2.
FIG. 9 is a block diagram illustrating a configuration of a base station 203 illustrated in FIG. 2.
FIG. 10 is a block diagram illustrating a configuration of an MME.
FIG. 11 is a block diagram illustrating a configuration of a 5GC unit.
FIG. 12 is a flowchart schematically illustrating a cell search to an idle state operation performed by a communication terminal (UE) in the LTE communication system.
FIG. 13 is a diagram illustrating an example of a configuration of a cell in an NR system.
FIG. 14 is a configuration diagram of a learning device related to a communication system in a first embodiment.
FIG. 15 is a diagram illustrating an example of a neural network used in learning of an encoding model and a decoding model in the first embodiment.
FIG. 16 is a flowchart regarding a learning process performed by the learning device in the first embodiment.
FIG. 17 is a configuration diagram of an inference device applied to an encoding device among inference devices related to the communication system in the first embodiment.
FIG. 18 is a diagram illustrating an example of a learned model used in an encoding unit in the first embodiment.
FIG. 19 is a flowchart regarding encoding in an inference process performed by the inference device in the first embodiment.
FIG. 20 is a configuration diagram of an inference device applied to a decoding device among inference devices related to the communication system in the first embodiment.
FIG. 21 is a diagram illustrating an example of a learned model used in a decoding unit in the first embodiment.
FIG. 22 is a flowchart regarding decoding in the inference process performed by the inference device in the first embodiment.
FIG. 23 is a sequence diagram illustrating a learning operation of encoding/decoding models of a CSI report and encoding/decoding operations using a learned model in the first embodiment.
FIG. 24 is a sequence diagram illustrating an example of switching of operation phases of the encoding/decoding models of the CSI report in a first modification of the first embodiment.
FIG. 25 is a diagram illustrating an example of communication between a base station and a UE that can use the encoding/decoding models and a UE that cannot use the encoding/decoding models in a second embodiment.
FIG. 26 is a diagram illustrating an example of communication between the base station and UEs having different categories of learning devices in the second embodiment.
FIG. 27 is a diagram illustrating an example of a case where the encoding model/decoding model are provided for each UE in a first modification of the second embodiment.
FIG. 28 is a diagram illustrating an example of a case where the encoding model/decoding model are provided to be shared between different UEs in the first modification of the second embodiment.
FIG. 29 is a sequence diagram illustrating an operation in a case where learning of the encoding model/decoding model is performed simultaneously for all UEs belonging to a group in the first modification of the second embodiment.
FIG. 30 is a sequence diagram illustrating an operation in a case where learning of the encoding model/decoding model is performed only for one or some of UEs belonging to the group in the first modification of the second embodiment.

### Description of Embodiments

Hereinafter, a communication system according to each embodiment of the present disclosure will be described in detail with reference to the drawings.

### First Embodiment.

FIG. 2 is a block diagram illustrating an overall configuration of an LTE communication system 200 that has been discussed in 3GPP. FIG. 2 will be described. A radio access network is referred to as an evolved universal terrestrial radio access network (E-UTRAN) 201. A user equipment device (hereinafter referred to as "user equipment (UE)") 202 which is a communication terminal device can perform radio communication with a base station device (hereinafter referred to as "base station (E-UTRAN NodeB (eNB))") 203, and transmits and receives signals by radio communication.

Here, the "communication terminal device" includes not only a user equipment device such as a mobile phone terminal device that is movable, but also a non-moving device such as a sensor. In the following description, the "communication terminal device" may be simply referred to as a "communication terminal".

If a control protocol for the user equipment 202, for example, radio resource control (RRC), and a user plane (hereinafter, sometimes referred to as a U-plane), for example, a packet data convergence protocol (PDCP), radio link control (RLC), medium access control (MAC), or a physical layer (PHY), are terminated in the base station 203, the E-UTRAN includes one or a plurality of base stations 203.

Radio resource control (RRC) as a control protocol between the user equipment 202 and the base station 203 performs broadcast, paging, RRC connection management, and the like. As states of the base station 203 and the user equipment 202 in RRC, there are RRC_IDLE and RRC_CONNECTED.

In RRC_IDLE, public land mobile network (PLMN) selection, broadcast of system information (SI), paging, cell re-selection, mobility, and the like are performed. In RRC_CONNECTED, the user equipment has RRC connection and can transmit and receive data to and from a network. In addition, in RRC_CONNECTED, handover (HO), measurement of a neighbor cell, and the like are performed.

The base station 203 includes one or a plurality of eNBs 207. A system including an evolved packet core (EPC) which is a core network and the E-UTRAN 201 which is a radio access network is referred to as an evolved packet system (EPS). The EPC which is a core network and the E-UTRAN 201 which is a radio access network may be collectively referred to as a "network".

Each eNB 207 is connected via an S1 interface to an MME/S-GW unit (hereinafter, sometimes referred to as an "MME unit") 204 including a mobility management entity (MME) or a serving gateway (S-GW), or the MME and the S-GW, and control information is communicated between the eNB 207 and the MME unit 204. A plurality of MME units 204 may be connected to one eNB 207. The eNBs 207 are connected to each other via an X2 interface, and the control information is communicated between the eNBs 207.

The MME unit 204 is a higher-level device, specifically, a higher-level node, and controls connection between the eNB 207 which is a base station and the user equipment (UE) 202. The MME unit 204 configures the EPC which is a core network. The base station 203 configures the E-UTRAN 201.

The base station 203 may configure one cell or a plurality of cells. Each cell has a predetermined range as a coverage which is a range in which communication with the user equipment 202 is possible, and performs radio communication with the user equipment 202 within the coverage. In a case where one base station 203 configures a plurality of cells, each cell is configured to be able to communicate with the user equipment 202.

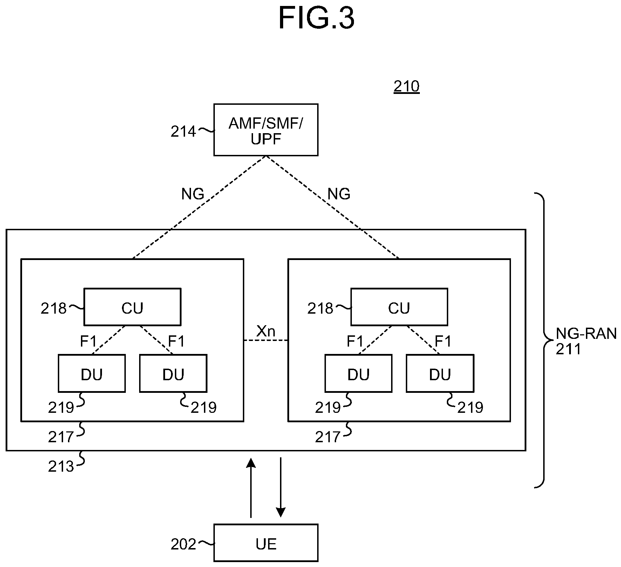

FIG. 3 is a block diagram illustrating an overall configuration of a 5G communication system 210 that has been discussed in 3GPP. FIG. 3 will be described. The radio access network is referred to as a next generation radio access network (NG-RAN) 211. The UE 202 can perform radio communication with an NR base station device (hereinafter referred to as an "NR base station (NG-RAN NodeB (gNB))") 213, and transmits and receives signals by radio communication. The core network is referred to as a 5G core (5GC).

If a control protocol for the UE 202, for example, radio resource control (RRC), and a user plane (hereinafter, sometimes referred to as a U-plane), for example, service data adaptation protocol (SDAP), packet data convergence protocol (PDCP), radio link control (RLC), medium access control (MAC), or physical layer (PHY), are terminated in the NR base station 213, the NG-R_AN includes one or a plurality of NR base stations 213.

A function of radio resource control (RRC) as a control protocol between the UE 202 and the NR base station 213 is similar to that of LTE. As states of the NR base station 213 and the UE 202 in RRC, there are RRC_IDLE, RRC_CONNECTED, and RRC_INACTIVE.

RRC_IDLE and RRC_CONNECTED are similar to those in the LTE system. In RRC_INACTIVE, broadcast of system information (SI), paging, cell re-selection, mobility, and the like are performed while connection between the 5G core and the NR base station 213 is maintained.

Each gNB 217 is connected via an NG interface to an AMF/SMF/UPF unit (hereinafter, sometimes referred to as a "5GC unit") 214 including an access and mobility management function (AMF), a session management function (SMF), or a user plane function (UPF), or the AMF, the SMF, and the UPF. Control information and/or user data is communicated between each gNB 217 and the 5GC unit 214. The NG interface is a generic term for an N2 interface between each gNB 217 and the AMF, an N3 interface between each gNB 217 and the UPF, an N11 interface between the AMF and the SMF, and an N4 interface between the UPF and the SMF. A plurality of 5GC units 214 may be connected to one gNB 217. The gNBs 217 are connected to each other via an Xn interface, and control information and/or user data is communicated between the gNBs 217.

The 5GC unit 214 is a higher-level device, specifically, a higher-level node, and distributes paging signals to one or a plurality of base stations 203 and/or base stations 213. In addition, the 5GC unit 214 performs mobility control in an idle state. The 5GC unit 214 manages a tracking area list when the user equipment 202 is in the idle state, an inactive state, and an active state. The 5GC unit 214 starts a paging protocol by transmitting a paging message to a cell belonging to a tracking area in which the user equipment 202 is registered.

The NR base station 213 may also configure one or a plurality of cells similarly to the base station 203. In a case where one NR base station 213 configures a plurality of cells, each cell is configured to be able to communicate with the UE 202.

The gNB 217 may be divided into a central unit (hereinafter, sometimes referred to as a CU) 218 and a distributed unit (hereinafter, sometimes referred to as a DU) 219. One CU 218 is configured in the gNB 217. One or a plurality of DUs 219 are configured in the gNB 217. The CU 218 is connected to the DU 219 via the F1 interface, and control information and/or user data is communicated between the CU 218 and the DU 219.

A unified data management (UDM) function and a policy control function (PCF) described in Non Patent Literature 21 (3GPP TS23.501) may be included in the 5G communication system. The UDM and/or the PCF may be included in the 5GC unit 214 in FIG. 3.

A location management function (LMF) described in Non Patent Literature 24 (3GPP TS 38.305) may be provided in the 5G communication system. The LMF may be connected to a base station via the AMF as disclosed in Non Patent Literature 25 (3GPP TS 23.273).

A non-3GPP interworking function (N3IWF) described in Non Patent Literature 21 (3GPP TS23.501) may be included in the 5G communication system. The N3IWF may terminate an access network (AN) with the UE in non-3GPP access with the UE.

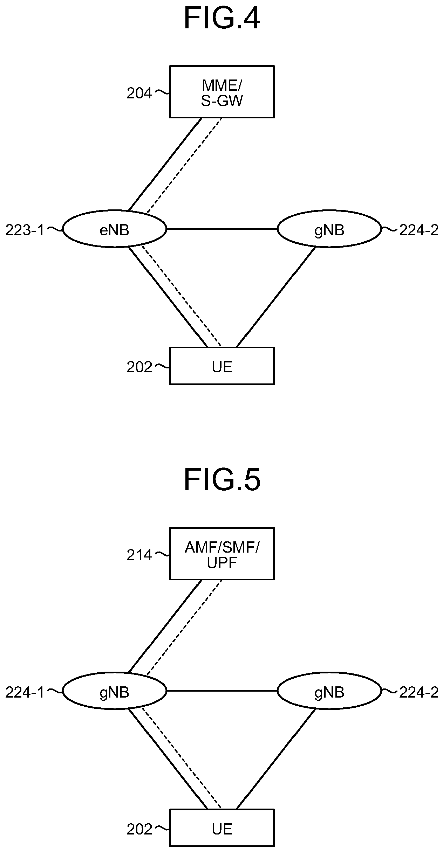

FIG. 4 is a diagram illustrating a configuration of DC performed by an eNB and a gNB connected to the EPC. In FIG. 4, solid lines each indicate U-plane connection, and broken lines each indicate C-plane connection. In FIG. 4, an eNB 223-1 serves as a master base station, and a gNB 224-2 serves as a secondary base station (this DC configuration is sometimes referred to as EN-DC). Although FIG. 4 illustrates an example in which the U-plane connection between the MME unit 204 and the gNB 224-2 is established via the eNB 223-1, the U-plane connection may be directly established between the MME unit 204 and the gNB 224-2.

FIG. 5 is a diagram illustrating a configuration of DC performed by gNBs connected to an NG core. In FIG. 5, solid lines each indicate U-plane connection, and broken lines each indicate C-plane connection. In FIG. 5, a gNB 224-1 serves as a master base station, and the gNB 224-2 serves as a secondary base station (this DC configuration is sometimes referred to as NR-DC). Although FIG. 5 illustrates an example in which the U-plane connection between the 5GC unit 214 and the gNB 224-2 is established via the gNB 224-1, the U-plane connection may be directly established between the 5GC unit 214 and the gNB 224-2.

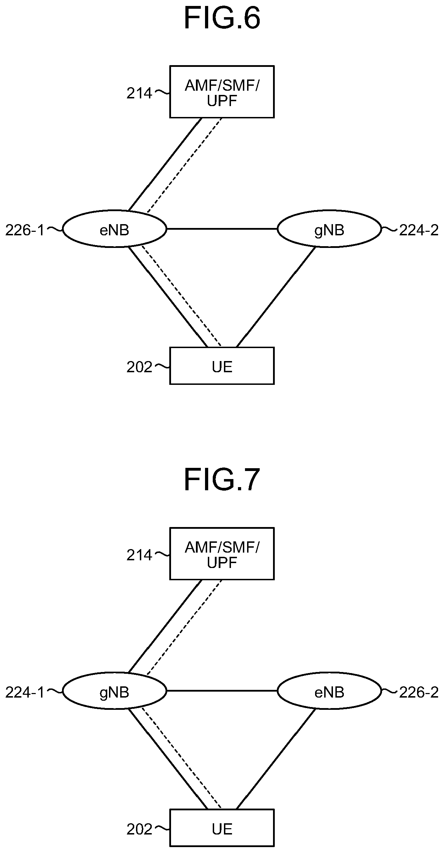

FIG. 6 is a diagram illustrating a configuration of DC performed by an eNB and the gNB connected to the NG core. In FIG. 6, solid lines each indicate U-plane connection, and broken lines each indicate C-plane connection. In FIG. 6, an eNB 226-1 serves as a master base station, and the gNB 224-2 serves as a secondary base station (this DC configuration is sometimes referred to as NG-EN-DC). Although FIG. 6 illustrates an example in which the U-plane connection between the 5GC unit 214 and the gNB 224-2 is established via the eNB 226-1, the U-plane connection may be directly established between the 5GC unit 214 and the gNB 224-2.

FIG. 7 is a diagram illustrating another configuration of DC performed by an eNB and the gNB connected to the NG core. In FIG. 7, solid lines each indicate U-plane connection, and broken lines each indicate C-plane connection. In FIG. 7, the gNB 224-1 serves as a master base station, and an eNB 226-2 serves as a secondary base station (this DC configuration is sometimes referred to as NE-DC). Although FIG. 7 illustrates an example in which the U-plane connection between the 5GC unit 214 and the eNB 226-2 is established via the gNB 224-1, the U-plane connection may be directly established between the 5GC unit 214 and the eNB 226-2.

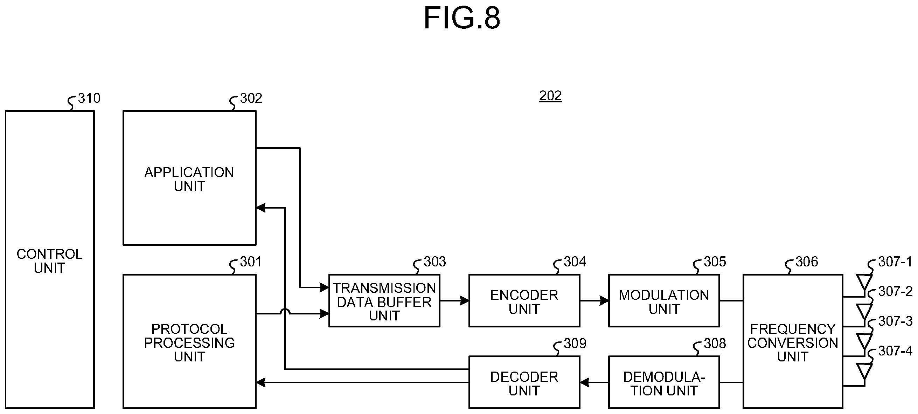

FIG. 8 is a block diagram illustrating a configuration of the user equipment 202 illustrated in FIG. 2. A transmission process performed by the user equipment 202 illustrated in FIG. 8 will be described. First, control data from a protocol processing unit 301 and user data from an application unit 302 are stored in a transmission data buffer unit 303. The data stored in the transmission data buffer unit 303 is passed to an encoder unit 304, and an encoding process such as error correction is performed thereon. There may be data output from the transmission data buffer unit 303 to a modulation unit 305 directly without being subjected to the encoding process. The data encoded by the encoder unit 304 is subjected to a modulation process by the modulation unit 305. The modulation unit 305 may perform precoding in MIMO. The modulated data is converted into a baseband signal, and then the baseband signal is output to a frequency conversion unit 306 to be converted into a radio transmission frequency. Thereafter, transmission signals are transmitted to the base station 203 from antennas 307-1 to 307-4. FIG. 8 exemplifies a case where the number of antennas is four, but the number of antennas is not limited to four.

The user equipment 202 executes a reception process as follows. A radio signal from the base station 203 is received by each of the antennas 307-1 to 307-4. The received signal is converted from a radio reception frequency into a baseband signal by the frequency conversion unit 306, and a demodulation process is performed thereon by a demodulation unit 308. The demodulation unit 308 may perform a weight calculation and a multiplication process. The demodulated data is passed to a decoder unit 309, and a decoding process such as error correction is performed thereon. Among pieces of the decoded data, the control data is passed to the protocol processing unit 301, and the user data is passed to the application unit 302. A series of processes of the user equipment 202 is controlled by a control unit 310. Therefore, although not illustrated in FIG. 8, the control unit 310 is connected to each of components 301 to 309. The control unit 310 is implemented by, for example, processing circuitry configured to include a processor and a memory. That is, the control unit 310 is implemented by the processor executing a program in which a series of processes of the user equipment 202 is described. The program in which a series of processes of the user equipment 202 is described is stored in the memory. Examples of the memory include a nonvolatile or volatile semiconductor memory such as a random access memory (RAM), a read only memory (ROM), or a flash memory. The control unit 310 may be implemented by dedicated processing circuitry such as a field programmable gate array (FPGA), an application specific integrated circuit (ASIC), or a digital signal processor (DSP). In FIG. 8, the number of antennas used by the user equipment 202 for transmission and the number of antennas used thereby for reception may be the same as or different from each other.

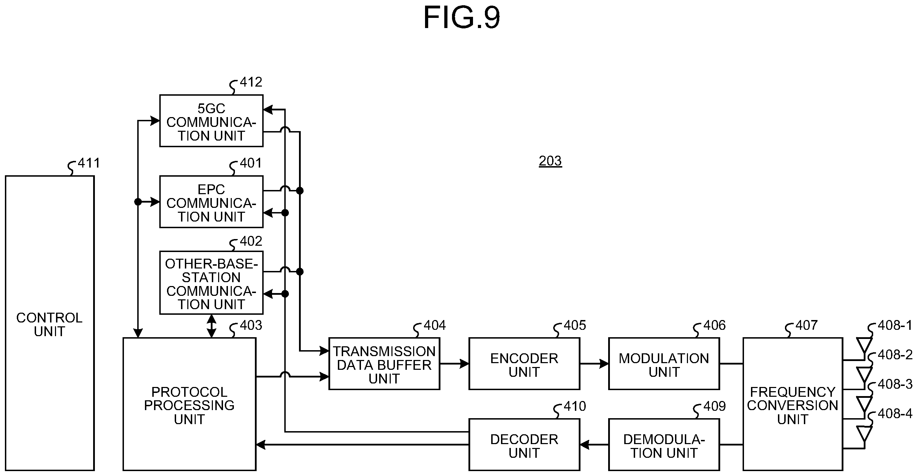

FIG. 9 is a block diagram illustrating a configuration of the base station 203 illustrated in FIG. 2. A transmission process performed by the base station 203 illustrated in FIG. 9 will be described. An EPC communication unit 401 transmits and receives data between the base station 203 and the EPC (such as the MME unit 204). A 5GC communication unit 412 transmits and receives data between the base station 203 and the 5GC (such as the 5GC unit 214). An other-base-station communication unit 402 transmits and receives data to and from other base stations. The EPC communication unit 401, the 5GC communication unit 412, and the other-base-station communication unit 402 each exchange information with a protocol processing unit 403. Control data from the protocol processing unit 403 and user data and control data from the EPC communication unit 401, the 5GC communication unit 412, and the other-base-station communication unit 402 are stored in a transmission data buffer unit 404.

The data stored in the transmission data buffer unit 404 is passed to an encoder unit 405, and an encoding process such as error correction is performed thereon. There may be data output from the transmission data buffer unit 404 to a modulation unit 406 directly without being subjected to the encoding process. The encoded data is subjected to a modulation process by the modulation unit 406. The modulation unit 406 may perform precoding in MIMO. The modulated data is converted into a baseband signal, and then the baseband signal is output to a frequency conversion unit 407 to be converted into a radio transmission frequency. Thereafter, transmission signals are transmitted from antennas 408-1 to 408-4 to one or a plurality of UEs 202. FIG. 9 exemplifies a case where the number of antennas is four, but the number of antennas is not limited to four.

The base station 203 executes a reception process as follows. Radio signals from one or a plurality of UEs 202 are received by the antennas 408. The received signals are each converted from a radio reception frequency into a baseband signal by the frequency conversion unit 407, and a demodulation process is performed thereon by a demodulation unit 409. The demodulated data is passed to a decoder unit 410, and a decoding process such as error correction is performed thereon. Among pieces of the decoded data, the control data is passed to the protocol processing unit 403, the 5GC communication unit 412, the EPC communication unit 401, or the other-base-station communication unit 402, and the user data is passed to the 5GC communication unit 412, the EPC communication unit 401, or the other-base-station communication unit 402. A series of processes of the base station 203 is controlled by a control unit 411. Therefore, although not illustrated in FIG. 9, the control unit 411 is connected to each of components 401 to 410, and 412. Similarly to the control unit 310 of the user equipment 202 described above, the control unit 411 is implemented by processing circuitry configured to include a processor and a memory, or dedicated processing circuitry such as an FPGA, an ASIC, or a DSP. In FIG. 9, the number of antennas used by the base station 203 for transmission and the number of antennas used thereby for reception may be the same as or different from each other.

FIG. 9 is a block diagram illustrating the configuration of the base station 203, but the base station 213 may have a configuration similar thereto. In addition, in FIGS. 8 and 9, the number of antennas of the user equipment 202 and the number of antennas of the base station 203 may be the same as or different from each other.

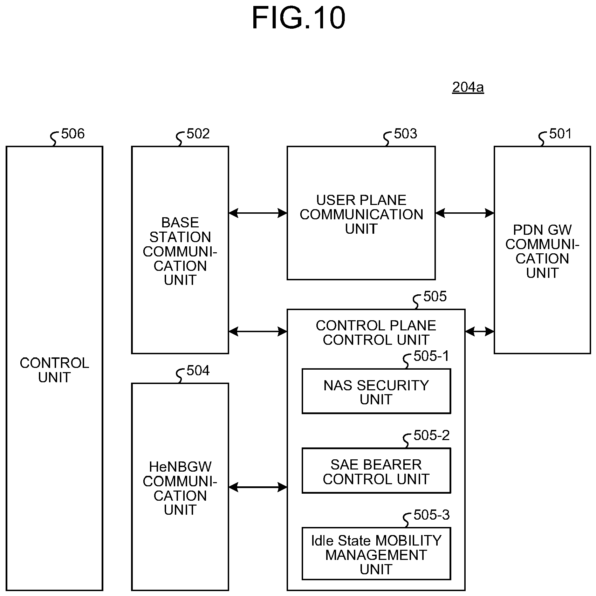

FIG. 10 is a block diagram illustrating a configuration of an MME. FIG. 10 illustrates a configuration of an MME 204a included in the MME unit 204 illustrated in FIG. 2 described above. A PDN GW communication unit 501 transmits and receives data between the MME 204a and a packet data network gate way (PDN GW). A base station communication unit 502 transmits and receives data between the MME 204a and the base station 203 via the S1 interface. In a case where data received from the PDN GW is user data, the user data is passed from the PDN GW communication unit 501 to the base station communication unit 502 via a user plane communication unit 503, and transmitted to one or a plurality of base stations 203. In a case where data received from the base station 203 is user data, the user data is passed from the base station communication unit 502 to the PDN GW communication unit 501 via the user plane communication unit 503, and transmitted to the PDN GW.

In a case where the data received from the PDN GW is control data, the control data is passed from the PDN GW communication unit 501 to a control plane control unit 505. In a case where the data received from the base station 203 is control data, the control data is passed from the base station communication unit 502 to the control plane control unit 505.

A HeNBGW communication unit 504 transmits and receives data between the MME 204a and a home-eNB gate way (HeNB GW). Control data received by the HeNBGW communication unit 504 from the HeNB GW is passed to the control plane control unit 505. The HeNBGW communication unit 504 transmits control data input from the control plane control unit 505 to the HeNB GW.

The control plane control unit 505 includes a NAS security unit 505-1, an SAE bearer control unit 505-2, an idle state mobility management unit 505-3, and the like, and performs overall processes on a control plane (hereinafter, sometimes referred to as a C-plane). The NAS security unit 505-1 provides security of a non-access stratum (NAS) message and the like. The SAE bearer control unit 505-2 performs management of system architecture evolution (SAE) bearers, and the like. The idle state mobility management unit 505-3 performs mobility management of an idle state (LTE-IDLE state or also simply referred to as idle), generation and control of a paging signal in the idle state, addition, deletion, update, and search of a tracking area of one or a plurality of UEs 202 under the management thereof, tracking area list management, and the like.

The MME 204a distributes paging signals to one or a plurality of base stations 203. In addition, the MME 204a performs mobility control in the idle state. The MME 204a manages a tracking area list when the user equipment 202 is in the idle state and an active state. The MME 204a starts a paging protocol by transmitting a paging message to a cell belonging to a tracking area in which the user equipment 202 is registered. The idle state mobility management unit 505-3 may manage CSG of the eNB 207 connected to the MME 204a, CSG IDs, and a whitelist.

A series of processes of the MME 204a is controlled by a control unit 506. Therefore, although not illustrated in FIG. 10, the control unit 506 is connected to each of components 501 to 505. Similarly to the control unit 310 of the user equipment 202 described above, the control unit 506 is implemented by processing circuitry configured to include a processor and a memory, or dedicated processing circuitry such as an FPGA, an ASIC, or a DSP.

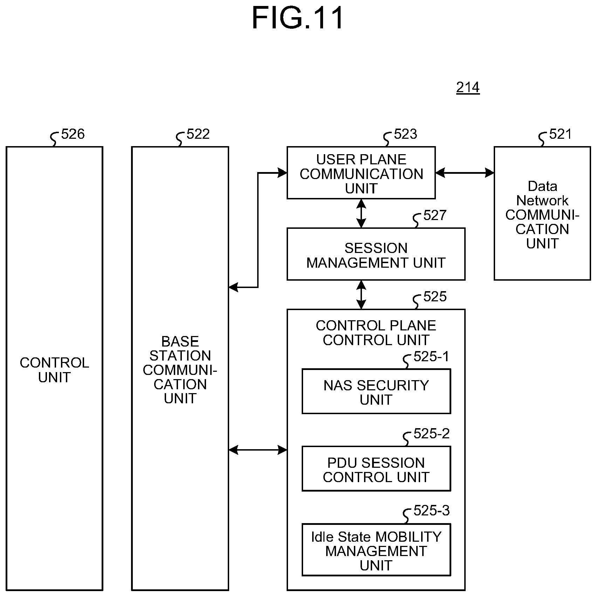

FIG. 11 is a block diagram illustrating a configuration of the 5GC unit. FIG. 11 illustrates a configuration of the 5GC unit 214 illustrated in FIG. 3 described above. FIG. 11 illustrates a case where a configuration of the AMF, a configuration of the SMF, and a configuration of the UPF are included in the 5GC unit 214 illustrated in FIG. 5. A data network communication unit 521 transmits and receives data between the 5GC unit 214 and a data network. A base station communication unit 522 transmits and receives data via the S1 interface between the 5GC unit 214 and the base station 203 and/or via the NG interface between the 5GC unit 214 and the base station 213. In a case where data received from the data network is user data, the user data is passed from the data network communication unit 521 to the base station communication unit 522 via a user plane communication unit 523, and transmitted to one or a plurality of base stations 203 and/or base stations 213. In a case where data received from the base station 203 and/or the base station 213 is user data, the user data is passed from the base station communication unit 522 to the data network communication unit 521 via the user plane communication unit 523, and transmitted to the data network.

In a case where data received from the data network is control data, the control data is passed from the data network communication unit 521 to a session management unit 527 via the user plane communication unit 523. The session management unit 527 passes the control data to a control plane control unit 525. In a case where data received from the base station 203 and/or the base station 213 is control data, the control data is passed from the base station communication unit 522 to the control plane control unit 525. The control plane control unit 525 passes the control data to the session management unit 527.

The control plane control unit 525 includes a NAS security unit 525-1, a PDU session control unit 525-2, an idle state mobility management unit 525-3, and the like, and performs overall processes on a control plane (hereinafter, sometimes referred to as a C-plane). The NAS security unit 525-1 provides security of a non-access stratum (NAS) message, and the like. The PDU session control unit 525-2 performs management of a PDU session between the user equipment 202 and the 5GC unit 214, and the like. The idle state mobility management unit 525-3 performs mobility management of an idle state (RRC-IDLE state or also simply referred to as idle), generation and control of a paging signal in the idle state, addition, deletion, update, and search of a tracking area of one or a plurality of UEs 202 under the management thereof, tracking area list management, and the like.

A series of processes of the 5GC unit 214 is controlled by a control unit 526. Therefore, although not illustrated in FIG. 11, the control unit 526 is connected to each of components 521 to 523, 525, and 527. Similarly to the control unit 310 of the user equipment 202 described above, the control unit 526 is implemented by processing circuitry configured to include a processor and a memory, or dedicated processing circuitry such as an FPGA, an ASIC, or a DSP.

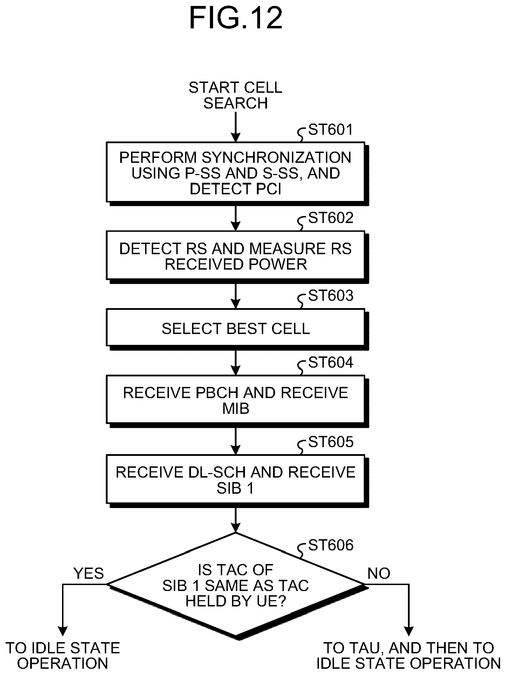

Next, an example of a cell search method in a communication system will be described. FIG. 12 is a flowchart schematically illustrating a cell search to an idle state operation performed by a communication terminal (UE) in the LTE communication system. When starting the cell search, in step ST601, the communication terminal synchronizes a slot timing and a frame timing using a primary synchronization signal (P-SS) and a secondary synchronization signal (S-SS) transmitted from a neighbor base station.

The P-SS and the S-SS are collectively referred to as a synchronization signal (SS). Synchronization codes that correspond one-to-one to PCIs are allocated to the synchronization signals (SSs), the PCIs being allocated on a per cell basis. As the number of PCIs, 504 different numbers are studied. The communication terminal performs synchronization using the 504 different numbers of PCIs and detects (specifies) a PCI of a synchronized cell.

Next, in step ST602, the communication terminal detects, for the synchronized cell, a cell-specific reference signal (CRS) which is a reference signal (RS) transmitted from the base station for each cell, and measures reference signal received power (RSRP). Codes that correspond one-to-one to the PCIs are used for reference signals (RSs). Separation from other cells can be performed by obtaining correlation using the codes. By deriving the code for the RS of the cell from the PCI specified in step ST601, it is possible to detect the RS and to measure the RS received power.

Next, in step ST603, the communication terminal selects a cell having the best RS reception quality, for example, a cell having the highest RS received power, that is, the best cell, from among the one or more cells detected up to step ST602.

Next, in step ST604, the communication terminal receives the PBCH of the best cell and obtains the BCCH which is broadcast information. A master information block (MIB) including cell configuration information is mapped to the BCCH on the PBCH. Accordingly, the MIB is obtained by receiving the PBCH to obtain the BCCH. Examples of the information of the MIB include a downlink (DL) system bandwidth (also referred to as transmission bandwidth configuration (dl-bandwidth)), the number of transmission antennas, and a system frame number (SFN).

Next, in step ST605, the communication terminal receives the DL-SCH of the cell on the basis of the cell configuration information of the MIB to obtain a system information block (SIB) 1 in the broadcast information BCCH. The SIB 1 includes information about access to the cell, information about cell selection, and scheduling information of other SIBs (SIB k; k is an integer equal to or greater than 2). The SIB 1 further includes a tracking area code (TAC).

Next, in step ST606, the communication terminal compares the TAC of the SIB 1 received in step ST605 with a TAC portion of a tracking area identity (TAI) in the tracking area list already held by the communication terminal. The tracking area list is also referred to as a TAI list. The TAI is identification information for identifying a tracking area, and includes a mobile country code (MCC), a mobile network code (MNC), and a tracking area code (TAC). The MCC is a country code. The MNC is a network code. The TAC is a code number of the tracking area.

If the TAC received in step ST605 is the same as the TAC included in the tracking area list as a result of the comparison in step ST606, the communication terminal enters an idle state operation in the cell. If the TAC received in step ST605 is not included in the tracking area list as a result of the comparison, the communication terminal requests, through the cell, a core network (EPC) including the MME or the like to change the tracking area in order to perform a tracking area update (TAU).

In the example illustrated in FIG. 12, from the cell search to the idle state operation in the LTE system are exemplified, but in the NR system, the best beam may be selected in addition to the best cell in step ST603. In addition, in the NR system, information on a beam, for example, a beam identifier may be acquired in step ST604. Furthermore, in the NR system, scheduling information of remaining minimum SI (RMSI) may be acquired in step ST604. In the NR system, the RMSI may be received in step ST605.

A device configuring a core network (hereinafter, sometimes referred to as a "core-network-side device") updates the tracking area list on the basis of an identification number (such as a UE-ID) of a communication terminal transmitted from the communication terminal together with a TAU request signal. The core-network-side device transmits the updated tracking area list to the communication terminal. The communication terminal rewrites (updates) the TAC list held by the communication terminal on the basis of the received tracking area list. Thereafter, the communication terminal enters an idle state operation in the cell.

The spread of smartphones and tablet terminal devices results in explosively increasing traffic in cellular radio communication, and there is a worldwide concern about a shortage of radio resources. In order to deal with the above to improve the spectral efficiency, downsizing of cells to advance spatial separation is under study.

In a conventional cell configuration, a cell configured by an eNB has a relatively wide range of coverage. A cell is conventionally configured to cover a certain area by such a relatively wide range of coverage of a plurality of cells configured by a plurality of eNBs.

In a case where cells are downsized, a cell configured by the eNB has a range of coverage narrower than the coverage of a cell configured by a conventional eNB. Accordingly, in order to cover a certain area similarly to conventional cases, a large number of eNBs configuring downsized cells as compared with the conventional eNBs are required.

In the following description, a cell having relatively large coverage such as the cell configured by a conventional eNB is referred to as a "macro cell", and an eNB configuring the macro cell is referred to as a "macro eNB". In addition, a cell having a relatively small coverage such as a downsized cell is referred to as a "small cell", and an eNB configuring the small cell is referred to as a "small eNB".

The macro eNB may be, for example, a "wide area base station" described in Non Patent Literature 7.

The small eNB may be, for example, a low power node, a local area node, a hotspot, or the like. In addition, the small eNB may be a pico eNB configuring a picocell, a femto eNB configuring a femtocell, a HeNB, a remote radio head (RRH), a remote radio unit (RRU), remote radio equipment (RRE), or a relay node (RN). Furthermore, the small eNB may be a "local area base station" or a "home base station" described in Non Patent Literature 7.

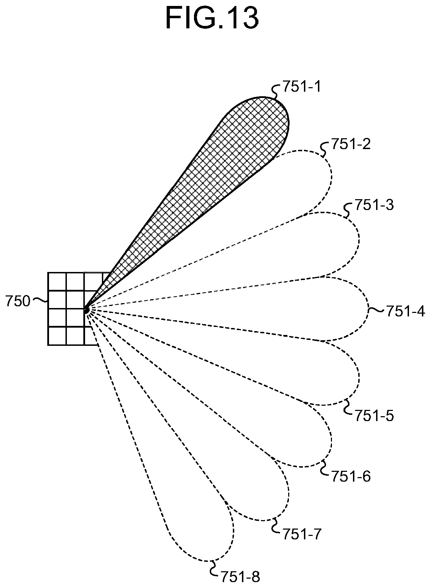

FIG. 13 illustrates an example of a configuration of a cell in NR. In the cell in NR, narrow beams are formed and transmitted in different directions. In the example illustrated in FIG. 13, a base station 750 performs transmission and reception to and from user equipment using a beam 751-1 at a certain time. The base station 750 performs transmission and reception to and from the user equipment using a beam 751-2 at another time. Thereafter, the base station 750 similarly performs transmission and reception to and from the user equipment using one or more of the beams 751-3 to 751-8. Thus, the base station 750 configures a cell with a wide range.

Although FIG. 13 illustrates an example in which the number of beams used by the base station 750 is eight, the number of beams may be different from eight. In addition, although the number of beams simultaneously used by the base station 750 is one in the example illustrated in FIG. 13, the number of beams may be two or more.

In 3GPP, sidelink (SL) is supported for device to device (D2D) communication and vehicle to vehicle (V2V) communication (see Non Patent Literatures 1 and 16). The SL is defined by a PC5 interface.

A physical channel (see Non Patent Literature 1) used for the SL will be described. A physical sidelink broadcast channel (PSBCH) carries information related to a system and synchronization, and is transmitted from a UE.

A physical sidelink discovery channel (PSDCH) carries a sidelink discovery message from a UE.

A physical sidelink control channel (PSCCH) carries control information from a UE for sidelink communication and V2X sidelink communication.

A physical sidelink shared channel (PSSCH) carries data from a UE for sidelink communication and V2X sidelink communication.

A physical sidelink feedback channel (PSFCH) carries HARQ feedback on the sidelink from a UE that has received PSSCH transmission to a UE that has transmitted the PSSCH.

A transport channel (see Non Patent Literature 1) used for the SL will be described. A sidelink broadcast channel (SL-BCH) has a predetermined transport format and is mapped to the PSBCH which is a physical channel.

A sidelink discovery channel (SL-DCH) has periodic broadcast transmission of a predetermined format having a fixed size. In addition, the SL-DCH supports both UE autonomous resource selection and resource allocation scheduled by eNB. In the UE autonomous resource selection, there is a collision risk, and when dedicated resources are allocated to a UE by an eNB, there is no collision. In addition, the SL-DCH supports HARQ combining but does not support HARQ feedback. The SL-DCH is mapped to the PSDCH which is a physical channel.

A sidelink shared channel (SL-SCH) supports broadcast transmission. The SL-SCH supports both UE autonomous resource selection and resource allocation scheduled by eNB. In the UE autonomous resource selection, there is a collision risk, and when dedicated resources are allocated to a UE by an eNB, there is no collision. In addition, the SL-SCH supports HARQ combining but does not support HARQ feedback. Furthermore, the SL-SCH supports dynamic link adaptation by changing transmission power, modulation, and coding. The SL-SCH is mapped to the PSSCH which is a physical channel.

A logical channel (see Non Patent Literature 1) used for the SL will be described. A sidelink broadcast control channel (SBCCH) is a sidelink channel for broadcasting sidelink system information from one UE to another UE. The SBCCH is mapped to the SL-BCH which is a transport channel.

A sidelink traffic channel (STCH) is a point-to-multipoint sidelink traffic channel for transmitting user information from one UE to another UE. The STCH is used only by a UE having a sidelink communication capability and a UE having a V2X sidelink communication capability. Point-to-point communication between two UEs having the sidelink communication capabilities is also realized by using the STCH. The STCH is mapped to the SL-SCH which is a transport channel.

A sidelink control channel (SCCH) is a sidelink control channel for transmitting control information from one UE to another UE. The SCCH is mapped to the SL-SCH which is a transport channel.

In 3GPP, support of V2X communication also in NR has been studied. The study of the V2X communication in NR has been progressed on the basis of the LTE system and the LTE-A system, but there are additions and changes to and from the LTE system and the LTE-A system in the following points.

In LTE, the SL communication uses broadcast only. In NR, as the SL communication, support of unicast and groupcast in addition to broadcast has been studied (see Non Patent Literature 22 (3GPP TS 23.287)).

Support of HARQ feedback (Ack/Nack), a CSI reporting, and the like in unicast communication and groupcast communication has been studied.

In order to support unicast and groupcast in addition to broadcast in the SL communication, support of PC5-S signaling has been studied (see Non Patent Literature 22 (3GPP TS 23.287)). For example, PC5-S signaling is implemented to establish a link for implementing SL, i.e., PC5 communication. The link is implemented in a V2X layer and is also referred to as a layer 2 link.

In addition, support of RRC signaling in the SL communication has been studied (see Non Patent Literature 22 (3GPP TS 23.287)). The RRC signaling in the SL communication is also referred to as PC5 RRC signaling. For example, it has been proposed to perform notifications, between UEs that perform PC5 communication, of capability of each UE, and of an AS layer configuration for performing the V2X communication using the PC5 communication.

A learning device may be used for communication control of NR, for example, PHY layer control. As an operation phase of the learning device, there may be a learning phase and an inference phase. An example of the learning device may be a learning device for which a UE encodes input data and a base station decodes the input data. The input data may be, for example, CSI. As a specific example, an encoding process and a decoding process of a CSI report may be performed between the UE and the base station by using an encoding model and a decoding model that have been learned (hereinafter, the CSI report may be used synonymously with the CSI). The UE may notify the base station of the encoded CSI report. The base station may decode the encoded CSI report and use the CSI report for communication control, for example, PHY layer control. The encoded CSI report may be smaller in size than the original CSI report.

However, a subject that performs learning used for communication control is not disclosed. As a result, there arises a problem in that communication control using the learning device is not performed.

The first embodiment discloses a method for solving such a problem.

Hereinafter, the learning phase will be described.

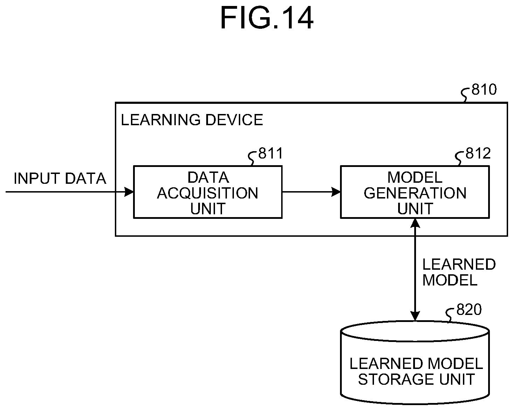

In a communication system according to the present embodiment, a configuration of a learning device illustrated in FIG. 14 is adopted. FIG. 14 is a configuration diagram of a learning device 810 related to the communication system. The learning device 810 includes a data acquisition unit 811 and a model generation unit 812. A learned model generated by the model generation unit 812 is stored in a learned model storage unit 820. Although FIG. 14 illustrates the exemplary configuration in which the learned model storage unit 820 is present outside the learning device 810, the learned model storage unit 820 may be configured to be included in the learning device 810. The learning device 810 illustrated in FIG. 14 may be applied to a base station, a UE, or a core network device, for example, an AMF, an SMF, or a UPF. As another example, the learning device 810 may be applied to an LMF, or a network data analytics function (NWDAF) (see Non Patent Literature 21 (3GPP TS 23.501)).

The data acquisition unit 811 acquires input data as learning data. The input data may be, for example, a CSI report received from the UE.

The model generation unit 812 learns an encoding model and a decoding model on the basis of input values output from the data acquisition unit 811, for example, learning data created on the basis of the CSI report. That is, an optimal encoding model and an optimal decoding model are created with which the UE can encode and transmit, to the base station, the CSI report that has been measured, and the base station can perform restoration to the original CSI report. Here, the encoded CSI report may be smaller in size than the original CSI report. The learning data may be the CSI report itself received from the UE. The learning data may include information about a process of the base station based on the CSI report, for example, information about transmission power control and/or information about scheduling.

Note that the learning device 810 is used to learn the encoding model and the decoding model of the CSI report, but may be, for example, a device that is connected via a network to a communication system device, for example, the base station and/or the UE, and is separate from the communication system device. Alternatively, the learning device 810 may be included in the communication system device. Further alternatively, the learning device 810 may be present on a cloud server. Although the example of the relationship between the learning device 810 and the communication system device has been described, the same applies to a relationship between an inference device to be described later and the communication system device. That is, the inference device to be described later may be a separate device connected via a network to the communication system device, may be included in the communication system device, or may be present on the cloud server.

As a learning algorithm used by the model generation unit 812, a known algorithm such as supervised learning, unsupervised learning, or reinforcement learning can be used. As one example, a case will be described where a neural network is applied.

The model generation unit 812 learns the encoding model and the decoding model by so-called supervised learning in accordance with, for example, a neural network model. Here, supervised learning is a method in which sets of data each including an input and a result (label) are given to a learning device, and thereby characteristics reside in the learning data are learned and results are inferred from inputs. In the learning of the encoding model and the decoding model, the input data itself may be used as data of the results.

A neural network includes an input layer including a plurality of neurons, an intermediate layer (hidden layer) including a plurality of neurons, and an output layer including a plurality of neurons. The intermediate layer may be one layer or two or more layers. As another example, the intermediate layer need not be present. Consequently, for example, it is possible to reduce the amount of processing of the communication system.

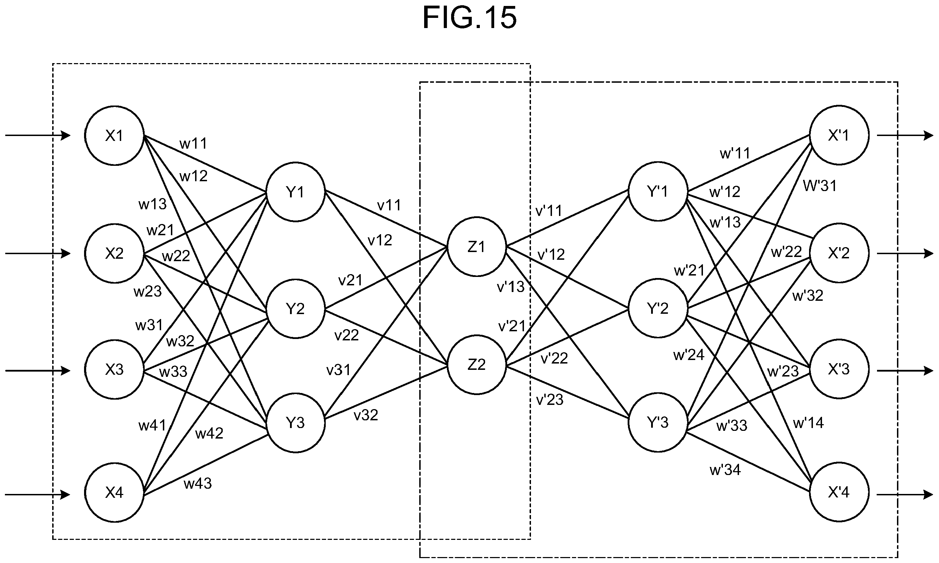

FIG. 15 illustrates an example of a neural network used in the learning of the encoding model and the decoding model. In the example illustrated in FIG. 15, layers surrounded by a broken line correspond to the encoding model used in an encoding unit, and layers surrounded by an alternate long and short dash line correspond to the decoding model used in a decoding unit. In the example illustrated in FIG. 15, when a plurality of input values, for example, CSI reports in different frequency bands are input to an input layer (X1 to X4), values thereof are multiplied by weights W1 (w11 to w43) and input to an intermediate layer (Y1 to Y3), and results thereof are further multiplied by weights V1 (v11 to v32) and input to an intermediate layer (Z1 to Z2). Results thereof vary depending on values of the weights W1 and the weights V1. The values of the intermediate layer (Z1 to Z2) are multiplied by weights V'1 (v'11 to v'23) and input to an intermediate layer (Y'1 to Y'3), and results thereof are further multiplied by weights W'1 (w'11 to w'34) and input to an output layer (X'1 to X'4). The output results vary depending on values of the weights W1, V1, V'1, and W'1.

The values input to the intermediate layers (Y1 to Y3), (Z1 to Z2), and (Y'1 to Y'3) and/or the output layer (X'1 to X'4) may be subjected to calculation by a predetermined function. The results of the calculation in the intermediate layers may be multiplied by the weights V1, V'1, and W'1 described above. The predetermined function may be, for example, a sigmoid function, a hyperbolic tangent function, or another function.

In the present application, the neural network learns the encoding model and the decoding model by so-called supervised learning in accordance with the learning data created on the basis of the input of the CSI report acquired by the data acquisition unit 811.

That is, the encoding model and the decoding model, for example, the weights W1, V1, V'1, and W'1, are learned such that the values of the output layer (X'1 to X'4) are the same as the values of the input layer (X1 to X4) .

The model generation unit 812 generates a learned model by executing learning as described above, and outputs the learned model.

The learned model storage unit 820 stores the learned model output from the model generation unit 812. The learned model storage unit 820 may notify another communication system device, for example, the UE of the learned model.

The learned model storage unit 820 may be included in the same device as that including the learning device, or a device different therefrom. For example, the learned model storage unit 820 may be included in the base station or a core NW device (e.g., AMF). Consequently, for example, it is possible to reduce memory usage of the UE.

The learned model storage unit 820 may be included in a plurality of devices. For example, the learned model storage unit 820 may be included in each of the same device as that including the learning device and a device different therefrom. For example, each of the base station and the UE may include the learned model storage unit 820. A plurality of devices may store the same learned model. The number of learned models stored in the learned model storage unit 820 may be, for example, two or more. For example, the base station and the UE may perform switching of models to be used from among a plurality of learned models, and use the models. Consequently, for example, it is possible to perform flexible CSI encoding/decoding on the basis of a channel state between the base station and the UE.

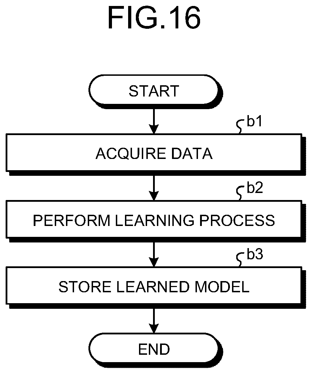

Next, a process of learning by the learning device 810 will be described with reference to FIG. 16. FIG. 16 is a flowchart regarding a learning process performed by the learning device 810.

In step b1, the data acquisition unit 811 acquires input data, for example, a CSI report. Note that the acquisition of the input data may be performed a plurality of times, the acquisition of respective pieces of input data may be performed at the same timing, or may be performed at different timings.

In step b2, the model generation unit 812 learns the encoding model and the decoding model by so-called supervised learning in accordance with the learning data created on the basis of the input data acquired by the data acquisition unit 811, for example, the CSI report, and creates a learned model.

In step b3, the learned model storage unit 820 stores the learned model created by the model generation unit 812. The learned model storage unit 820 may notify another communication system device, for example, the UE of the learned model, for example, the encoding model and/or the decoding model.

Next, the inference phase (utilization phase) will be described.

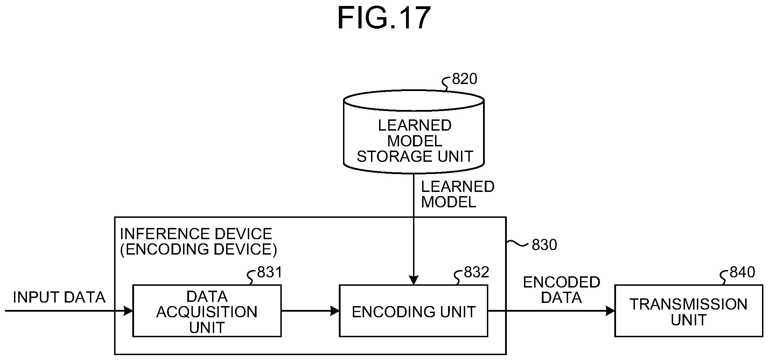

FIG. 17 is a configuration diagram of an inference device 830 applied to an encoding device among inference devices related to the communication system. The inference device 830 includes a data acquisition unit 831 and an encoding unit 832. The inference device 830 may be applied to, for example, the UE. Note that the learned model storage unit 820 is the same as the learned model storage unit 820 illustrated in FIG. 14.

The data acquisition unit 831 acquires input data, for example, a CSI report.

The encoding unit 832 encodes the input data by using the learned model. That is, by inputting the input data acquired by the data acquisition unit 831 to the learned model, encoded data can be output. The encoding unit 832 may output the encoded data to a transmission unit 840.

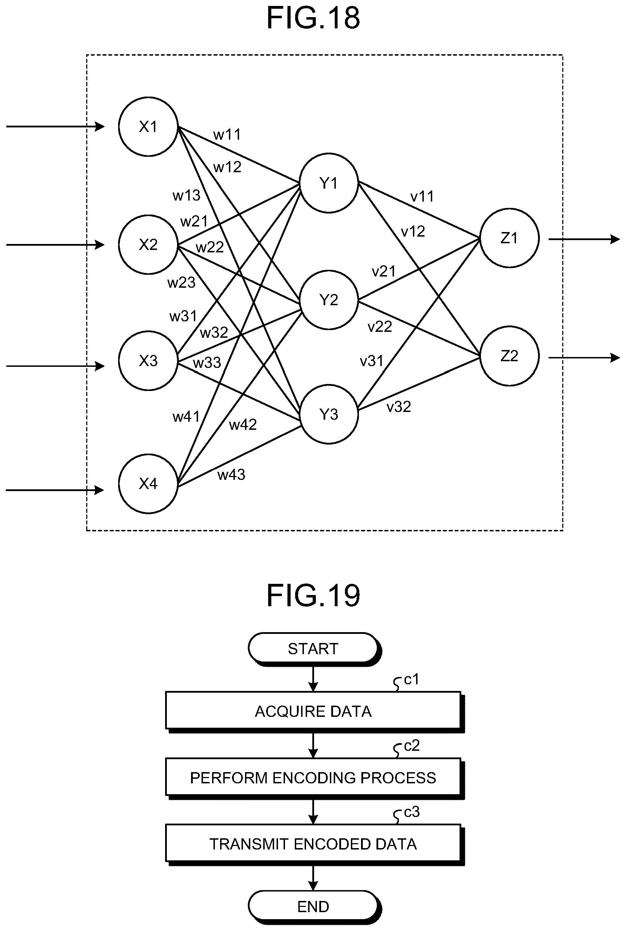

FIG. 18 illustrates an example of the learned model used in the encoding unit 832. The learned model illustrated in FIG. 18 is the same as the broken line part of the model illustrated in FIG. 15. When the input data acquired by the data acquisition unit 831, for example, the CSI report is input to the learned model illustrated in FIG. 18, the learned model outputs encoded data, for example, an encoded CSI report.

Note that, in the present embodiment, although it has been described that the inference device 830 outputs the encoded data encoded by using the learned model learned by the model generation unit 812 included in the learning device 810 of the communication system, a learned model may be acquired from outside, for example, another communication system device, and the encoded data may be output on the basis of the learned model.

Next, a process for obtaining an output of encoded data by using the inference device 830 will be described with reference to FIG. 19. FIG. 19 is a flowchart regarding encoding in an inference process performed by the inference device 830.

In step c1, the data acquisition unit 831 acquires input data, for example, a CSI report.

In step c2, the encoding unit 832 inputs the input data to the learned model stored in the learned model storage unit 820, and obtains encoded data output by the learned model.

In step c3, the encoding unit 832 transmits the encoded data obtained from the learned model to the base station. That is, the encoding unit 832 outputs the encoded data to the transmission unit 840, and the transmission unit 840 transmits the encoded data to the base station.

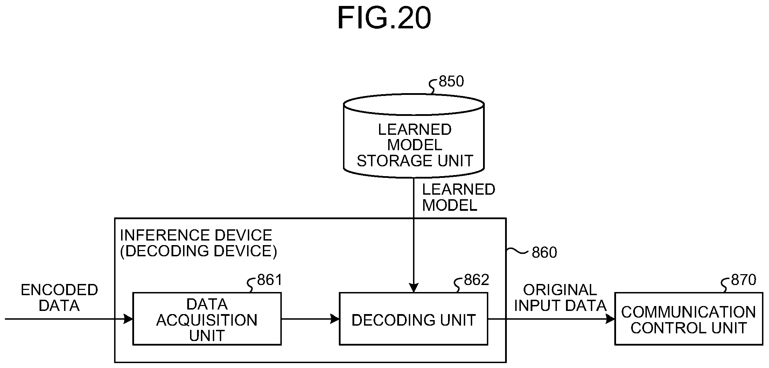

FIG. 20 is a configuration diagram of an inference device 860 applied to a decoding device among inference devices related to the communication system. The inference device 860 includes a data acquisition unit 861 and a decoding unit 862. The inference device 860 may be applied to, for example, the base station. A learned model storage unit 850 stores the decoding model generated by the model generation unit 812 of the learning device 810 described above as a learned model. Although FIG. 20 illustrates the exemplary configuration in which the learned model storage unit 850 is present outside the inference device 860, the learned model storage unit 850 may be configured to be included in the inference device 860. Similarly, for a communication control unit 870 that performs communication control of the base station on the basis of a result of decoding by the decoding unit 862, the communication control unit 870 may be configured not to be present outside the inference device 860, but to be included in the inference device 860. Control performed by the communication control unit 870 may be, for example, control in a PHY layer.

The data acquisition unit 861 acquires encoded data transmitted from the UE, for example, an encoded CSI report which is a CSI report that has been encoded.

The decoding unit 862 decodes the encoded data by using the learned model. That is, by inputting the encoded data acquired by the data acquisition unit to the learned model, the original input data before being encoded can be output.

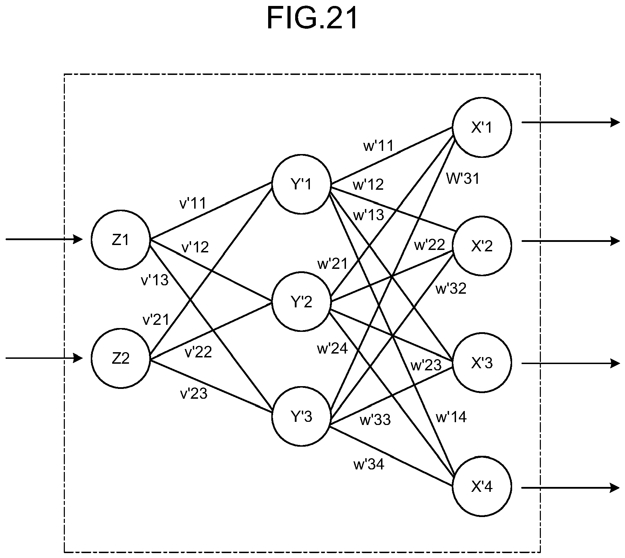

FIG. 21 illustrates an example of the learned model used in the decoding unit 862. The learned model illustrated in FIG. 21 is the same as the alternate long and short dash line part of the model illustrated in FIG. 15. When the encoded data acquired by the data acquisition unit 861 is input to the learned model illustrated in FIG. 21, the learned model outputs the original input data.

Note that, in the present embodiment, although it has been described that the inference device 860 outputs the decoded data decoded by using the learned model learned by the model generation unit 812 included in the learning device 810 of the communication system, a learned model may be acquired from outside, for example, another communication system device, and the decoded data may be output on the basis of the learned model.

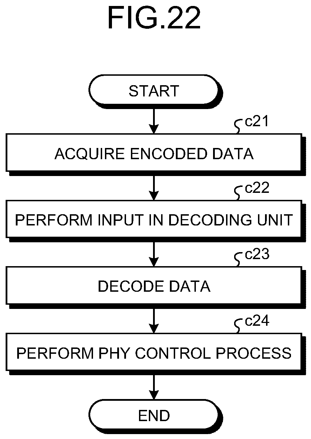

Next, a process for obtaining an output of decoded data by using the inference device 860 will be described with reference to FIG. 22. FIG. 22 is a flowchart regarding decoding in the inference process performed by the inference device 860.

In step c21, the data acquisition unit 861 acquires encoded data, for example, an encoded CSI report.

In step c22, the decoding unit 862 inputs the encoded data to the learned model stored in the learned model storage unit 850.

In step c23, the decoding unit 862 obtains a decoding result of the encoded data output by the learned model, for example, a CSI report.

In step c24, the communication control unit 870 performs communication control of the base station by using the original input data obtained by the learned model. The control may be, for example, control in the PHY layer. The communication control unit 870 may perform scheduling of the UE, for example, by using the original CSI report.

In applying the encoding model and/or the decoding model to the transmission and reception of the CSI report, the following problem further occurs. That is, details of a method for performing a configuration between the base station and the UE for the encoding model and/or the decoding model are not disclosed in the above-described Non Patent Literatures and the like. Therefore, there arises a problem in that encoding and decoding of a CSI report using the learning device cannot be realized.

A method for solving the above problem will be disclosed.

In order to solve the above problem, in the communication system according to the present embodiment, the encoding model/decoding model are learned in advance. For example, the base station may perform learning in advance. The learning in advance by the base station may be performed, for example, at the time of factory shipment of the base station or at the time of starting connection with the UE.

As another example, a core NW device which is a device constituting a core network may perform the learning. The core NW device may be, for example, an AMF, an SMF, a UPF, an LMF, or an NWDAF. The core NW device that has performed the learning may notify the base station and/or the UE of the encoding model/decoding model. For the notification, for example, an N2 interface may be used, or NAS signaling may be used. Consequently, for example, it is possible to reduce the amount of processing of the base station.

Default encoding model/decoding model may be provided. The models may be provided by the base station or the core NW device. One pair or a plurality of pairs of the default models may be provided. The base station may determine which one of the models to use by using the CSI report from the UE. Consequently, for example, it is possible to reduce the amount of processing of the base station in the learning phase.

As another example, the UE may perform the learning. The base station and the UE may perform the learning. Consequently, for example, notification of a learning result performed between the base station and the UE is no longer required, and as a result, the amount of signaling between the base station and the UE can be reduced.

As another solution, the learning may be performed as needed. For example, the learning may be performed by the base station. As an example in which the learning is performed as needed, the learning may be periodically performed, or may be performed as triggered by a sudden change in a channel state. A period and/or information (e.g., threshold) for determining a sudden change in the channel state may be determined in a standard, or may be determined by the base station and the base station may notify the UE thereof. For example, the base station may notify the UE of the threshold.

The base station may request learning data from the UE. The learning data may be un-encoded data, for example, an un-encoded CSI report. The request may be made by using RRC signaling, MAC signaling, or L1/L2 signaling. The UE may notify the base station of the learning data. RRC signaling, MAC signaling, or L1/L2 signaling may be used for the notification. As another example, user plane data (hereinafter, referred to as U-plane data) may be used for the notification. For example, U-plane data may be used for a notification of a measurement result of outside of the communication system. The base station may learn the encoding model/decoding model by using the data.

The request for the learning data may be made by the AMF. For example, NAS signaling may be used for the request made by the AMF to the UE. The UE may notify the AMF of the learning data. The UE may perform the notification via the base station. For the notification, for example, NAS signaling may be used, or RRC signaling and signaling over an N2 interface may be used. The AMF may perform learning by using the notification. Consequently, for example, it is possible to reduce the amount of processing of the base station.

The base station may notify the UE of the learned encoding model/decoding model. The following (1) to (12) will be disclosed as examples of information included in the notification to be performed by the base station to the UE.
(1) Type of input value.
(2) The number of nodes in the input layer.
(3) Depth of the hidden layer.
(4) The number of nodes in the hidden layer.
(5) A function applied to each node of the hidden layer.
(6) The number of nodes in the output layer.
(7) A function applied to each node of the output layer.
(8) Weighting coefficients for branches.
(9) Information about nodes to which branches join.
(10) Information about a default operation mode of the learning device.
(11) Binary information of a model.
(12) A combination of (1) to (11) described above.

The above (1) may be, for example, information indicating that it is a CSI report. The information may include details of the CSI report to be input, for example, information about resources (time, frequency, antenna port, and the like) of a CSI-RS to be measured. The UE may perform an encoding process of the CSI report by using the information. Consequently, for example, it is possible to avoid malfunction due to recognition inconsistency in input information between the base station and the UE.

The above (1) may include information about the type of CSI-RS to be measured. The information may be, for example, a zero-power CSI-RS (ZP-CSI-RS) or a non-zero power CSI-RS (NZP-CSI-RS) (see Non Patent Literature 13 (3GPP TS 38.211)), or channel state information-interference measurement (CSI-IM) (see Non Patent Literature 15 (3GPP TS 38.214)). Consequently, for example, it is possible to improve the flexibility of channel measurement.

The above (1) may be information about another input value. For example, the above (1) may be information about a positioning signal reception result. Consequently, for example, the other input value can also be encoded/decoded, and as a result, efficiency in the communication system can be improved.

The above (2) may be, for example, the number of nodes itself in the input layer, or an identifier indicating the number of nodes in the input layer. The association between the number of nodes in the input layer and the identifier may be determined in advance in a standard, may be determined by the base station and the base station may notify the UE thereof, or may be determined by the core NW device (e.g., AMF) and the core NW device may notify the base station and/or the UE thereof. The UE may configure the input layer of the encoding model by using the information. Consequently, for example, it is possible to construct the encoding model in the UE.

The above (3) may be information about the depth of the hidden layer in the encoding unit. In the example illustrated in FIG. 18, the depth of the hidden layer may be 1, that is, the hidden layer may be a layer including Y1 to Y3. The UE may construct the encoding model by using the information. Consequently, for example, it is possible to construct the encoding model in the UE.

The above (4) may include information about the number of nodes in each hidden layer. An identifier indicating the number of nodes may be used instead of the information about the number of nodes itself. The association between the number of nodes in the hidden layer and the identifier may be determined in advance in a standard, may be determined by the base station and the base station may notify the UE thereof, or may be determined by the core NW device (e.g., AMF) and the core NW device may notify the base station and/or the UE thereof. The UE may configure the hidden layer of the encoding model by using the information. Consequently, for example, it is possible to construct the encoding model in the UE.

The above (5) may include information about a function to be applied to an input value of each hidden layer. The function may be, for example, a sigmoid function or a hyperbolic tangent function. As another example, the function may be a linear function, or the function need not be applied, that is, an input value to the hidden layer and an output value therefrom may be equal. The UE may configure the hidden layer of the encoding model by using the information. For example, the flexibility of the encoding model and/or the decoding model can be improved by the information of the above (5).

The above (5) may include information about an offset to be added to the input value of each hidden layer. The offset may be, for example, a value to be added to a result obtained by adding, for each branch, a product of a weighting coefficient input to each hidden layer and a value of a previous layer. For example, the flexibility of the encoding model and/or the decoding model can be improved by the information.

Information about the above (5) may be given for each node. Consequently, for example, the flexibility of the encoding model and/or the decoding model can be improved. As another example, the information may be given for each hidden layer. That is, the information may be shared between nodes of the same layer. Consequently, for example, it is possible to reduce the amount of signaling of the information. As another example, the information may be shared between nodes. Consequently, for example, it is possible to further reduce the amount of signaling of the information.

The above (6) may include information about the number of nodes in the output layer. In the example illustrated in FIG. 18, the nodes in the output layer may be Z1 and Z2. An identifier indicating the number of nodes may be used instead of the information about the number of nodes itself. The association between the number of nodes in the output layer and the identifier may be determined in advance in a standard, may be determined by the base station and the base station may notify the UE thereof, or may be determined by the core NW device (e.g., AMF) and the core NW device may notify the base station and/or the UE thereof. The UE may configure the output layer of the encoding model by using the information. Consequently, for example, it is possible to construct the encoding model in the UE.

The above (7) may be information similar to the above (5). Consequently, for example, an effect similar to that of the above (5) is obtained.

Information about the above (7) may be given for each node. Consequently, for example, the flexibility of the encoding model and/or the decoding model can be improved. As another example, the information may be shared between nodes. Consequently, for example, it is possible to reduce the amount of signaling of the information.

Information on the above (8) may be given for each branch. The information may be respective values of w11 to w43 and v11 to v32 in the example illustrated in FIG. 18. The UE may configure branches between nodes by using the information. Consequently, for example, it is possible to construct the encoding model in the UE.

The information of the above (9) may include information about nodes at both ends of branches. The information about the nodes may be given by using, for example, an identifier of the entirety of the nodes, or a combination of information for identifying a layer and information for identifying a node in the layer. The UE may configure branches between nodes by using the information. Consequently, for example, it is possible to construct the encoding model in the UE.

Regarding the above (9), one or more layers may be present between both ends of a branch. For example, in the example illustrated in FIG. 18, there may be a branch which connects any one of X1 to X4 and any one of Z1 and Z2. As another example, both ends of a branch may be nodes of the same layer, or may be connected to the same node. Consequently, for example, it is possible to improve the flexibility of the encoding model.

The information of the above (10) may include information about an operating state of the encoding unit of the UE after the notification. The information may be, for example, information indicating that encoding is performed or information indicating that encoding is not performed. With the use of the information, the UE may perform or need not perform the encoding. Consequently, for example, inconsistency in the operation mode of the learning device between the base station and the UE can be prevented, and as a result, malfunction in the communication system can be prevented.

Regarding the information of the above (11), a notification thereof may be performed, for example, in a case where the base station and the UE use the same platform. The UE may configure the encoding model by using the information. Consequently, for example, it is possible to reduce the amount of signaling between the base station and the UE.

The base station may notify the UE of the information on the encoding model. RRC signaling may be used for the notification. The RRC signaling may be, for example, RRCReconfiguration, RRCResume, or RRCSetup. As another example, MAC signaling may be used for the notification. Consequently, for example, the notification can be promptly executed. As another example, L1/L2 signaling may be used for the notification. Consequently, for example, the notification can be more promptly executed.

The AMF may notify the UE of the information on the encoding model. For example, NAS signaling may be used for the notification. Consequently, for example, it is possible to reduce the amount of signaling in the base station.

The notification of the information on the encoding model may be performed by using U-plane data. For example, in a case where the learning process exists in an application layer, the notification may be performed by using the U-plane data. Consequently, for example, it is possible to reduce the amount of processing of a control plane (hereinafter, referred to as C-plane) in the communication system.

The base station may notify the UE of a configuration for encoding. For the configuration, for example, RRC signaling, MAC signaling, L1/L2 signaling, NAS signaling, or a combination of two or more of those described above may be used. The configuration may include information about the above (1) to (12). The UE may perform a configuration of encoding by using the information.

The configuration may be included for each piece of information on a target to be encoded/decoded. For example, the CSI report configuration may include the configuration for encoding, and a configuration for positioning may include the configuration for encoding. Consequently, for example, it is possible to promptly execute the configuration for the CSI report and/or positioning.

As another example, the configuration may include an encoding configuration of information on each target to be encoded/decoded. For example, the encoding configuration may include a configuration of encoding for the CSI report, and a configuration of encoding for positioning. Consequently, for example, it is possible to promptly execute the configuration for the encoding model.

The base station may instruct the UE to start encoding. The instruction may be made by using, for example, RRC signaling, MAC signaling, or L1/L2 signaling. Consequently, for example, inconsistency in encoding start timing between the base station and the UE can be prevented, and as a result, malfunction in the communication system can be prevented. The instruction may be included in signaling for performing the notification of the information on the encoding model, or may be performed as different signaling.

The notification of the encoding model may be an instruction to start encoding. For example, the UE may start the encoding of the CSI as triggered by the reception of the notification of the encoding model. Consequently, for example, it is possible to reduce the amount of signaling from the base station to the UE.

The UE may configure the encoding unit or encode the CSI report by using the notification. The encoding of the CSI report in the UE may be performed as triggered by the instruction to start encoding from the base station. The UE may transmit the encoded CSI report to the base station. The PUCCH or the PUSCH may be used for the transmission. Consequently, for example, it is possible to reduce the amount of signaling between the base station and the UE.

The base station may instruct the UE to stop the encoding. The instruction may be made by using, for example, RRC signaling, MAC signaling, or L1/L2 signaling. The UE may stop the encoding of the CSI or transmit the original CSI to the base station as triggered by the instruction. Consequently, for example, inconsistency in encoding stop timing between the base station and the UE can be prevented, and as a result, malfunction in the communication system can be prevented. The instruction may be included in signaling for requesting the learning data, or may be performed as different signaling.

The request for the learning data may be an instruction to stop the encoding. For example, the UE may stop the encoding of the CSI as triggered by the reception of the notification of the encoding model. Consequently, for example, it is possible to reduce the amount of signaling from the base station to the UE.

As another example, the learning data request need not be made along with the stop of the encoding, or transition to the learning phase need not be performed. The UE may perform phase switching by using a notification of switching of operation phases of the encoding/decoding models of the CSI report to be described later.

As another example, a phase of an operation different from that in the learning phase or the inference phase, for example, a normal operation may be provided. The UE may transition to the phase of the normal operation along with the stop of the encoding. In the phase of the normal operation, the UE need not perform the encoding, that is, may notify the base station of the original CSI. Consequently, for example, it is possible to improve the flexibility of the communication system.

For example, the encoding may be resumed. The base station may instruct the UE to resume the encoding. The instruction may be made by using, for example, RRC signaling, MAC signaling, or L1/L2 signaling. The UE may resume the encoding as triggered by the instruction. The UE may resume the encoding by using the encoding model before the stop of the encoding. Consequently, for example, it is possible to improve the flexibility of the communication system.

For example, the encoding may be ended. The base station may instruct the UE to end the encoding. The instruction may be made by using, for example, RRC signaling, MAC signaling, or L1/L2 signaling. The UE may end the encoding as triggered by the instruction. For example, the UE may release the configuration for encoding by using the instruction, or may make the CSI report by using the original CSI. Consequently, for example, it is possible to reduce the amount of processing of the UE.

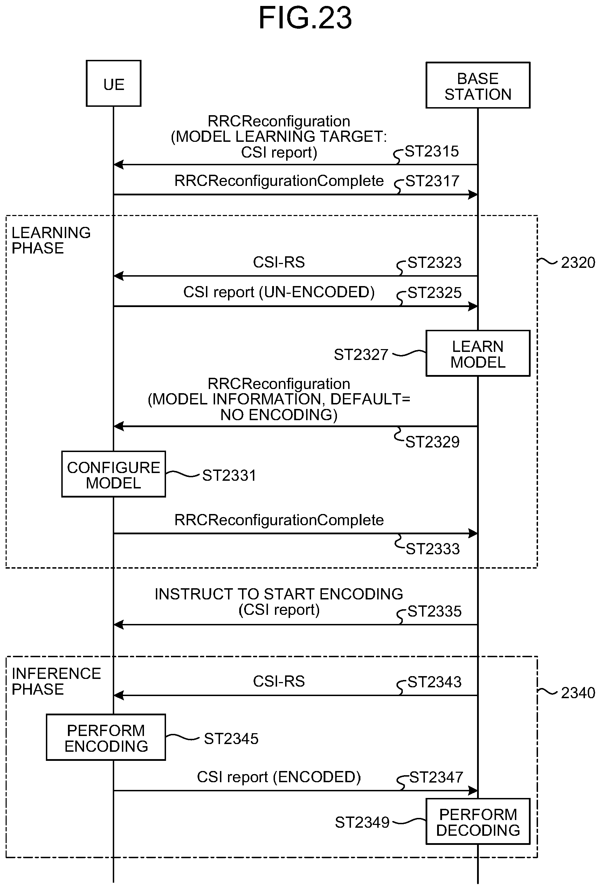

FIG. 23 is a sequence diagram illustrating a learning operation of the encoding/decoding models of the CSI report and encoding/decoding operations using the learned model. FIG. 23 illustrates an example in which the base station learns the encoding/decoding models, the UE performs encoding, and the base station performs decoding.

In step ST2315 illustrated in FIG. 23, the base station instructs the UE to perform a channel configuration. For the instruction, signaling of RRCReconfiguration may be used. The base station may include, in the signaling, information indicating the start of learning of the encoding/decoding models, a request for learning data to the UE, information indicating that the learning data is the CSI report, or a configuration of a CSI-RS to be transmitted to the UE. The UE may use the information to perform the channel configuration or to recognize that the CSI report is to be transmitted to the base station. In step ST2317, the UE notifies the base station of the completion of RRCReconfiguration.

Procedure 2320 illustrated in FIG. 23 is a procedure indicating the learning phase of the encoding/decoding models.

In step ST2323 illustrated in FIG. 23, the base station transmits the CSI-RS to the UE. The CSI-RS may be, for example, a zero-power CSI-RS (ZP-CSI-RS) or a non-zero power CSI-RS (NZP-CSI-RS) (see Non Patent Literature 13 (3GPP TS 38.211)), or channel state information-interference measurement (CSI-IM) (see Non Patent Literature 15 (3GPP TS 38.214)). The UE receives the CSI-RS from the base station and transmits a CSI report to the base station in step ST2325. The CSI report included in step ST2325 is an un-encoded CSI report. Step ST2323 and/or step ST2325 may be performed a plurality of times. In step ST2327, the base station learns the encoding/decoding models of the CSI report. The CSI report received in step ST2325 may be used for the learning.

In step ST2329 illustrated in FIG. 23, the base station notifies the UE of information about the encoding model that has been learned. For the notification, RRC signaling, for example, signaling of RRCReconfiguration may be used. The notification may include, for example, the information indicated in the above (1) to (12). In the example illustrated in FIG. 23, a default operation phase of the encoding model is no encoding. In step ST2331, the UE configures the encoding model. For the configuration, the information included in step ST2329 may be used. In the example illustrated in FIG. 23, the UE may employ no encoding as an initial operation of the encoding model after the model configuration. That is, the UE may transmit the un-encoded CSI report to the base station immediately after step ST2331. In step ST2333, the UE notifies the base station of the completion of the configuration of the encoding model. For the notification, RRC signaling, for example, signaling of RRCReconfigurationComplete may be used.

In step ST2335 illustrated in FIG. 23, the base station instructs the UE to start encoding. The instruction may include information about an input to be encoded. The information may be, for example, an identifier indicating the input. In the example illustrated in FIG. 23, information indicating the CSI report (e.g., identifier) is included. For the instruction, RRC signaling, for example, RRCReconfiguration may be used, or MAC signaling or L1/L2 signaling may be used.

Procedure 2340 illustrated in FIG. 23 is a procedure indicating the inference phase of the encoding/decoding models.

In step ST2343 illustrated in FIG. 23, the base station transmits the CSI-RS to the UE. The UE receives the CSI-RS from the base station and encodes the CSI report in step ST2345. In step ST2347, the UE transmits the encoded CSI report to the base station. In step ST2349, the base station decodes the encoded CSI report to generate the original CSI report. The base station performs communication control, for example, PHY layer control, by using the CSI report output in step ST2349.

FIG. 23 illustrates a case where steps ST2329 and ST2335 are signalings different from each other, but steps ST2329 and ST2335 may be the same signaling. For example, step ST2335 may be included in step ST2329. Consequently, for example, the UE can promptly start the encoding.

As another example, the encoding may be started as triggered by the reception in step ST2329. Consequently, for example, the UE can promptly start the encoding.

Although the example has been described in which signaling of RRCReconfiguration is used in step ST2315 illustrated in FIG. 23, signaling of RRCResume may be used. The signaling may be used, for example, when the UE is in an RRC_INACTIVE state. Consequently, for example, the UE can promptly start the learning phase after returning from RRC_INACTIVE, and the amount of signaling in the communication system can be reduced. As another example, signaling of RRCSetup may be used. The signaling may be used, for example, when the UE is in an RRC_IDLE state. Consequently, for example, the UE can promptly start the learning phase after transition from the RRC_IDLE state to an RRC_CONNECTED state, and the amount of signaling in the communication system can be reduced.

In the present embodiment, the case of encoding/decoding the CSI report has been described, but encoding/decoding of other information may be performed. For example, encoding/decoding of a report of a beam measurement result may be performed, or encoding/decoding of a report of a reception result of a signal used for positioning may be performed. Consequently, for example, it is possible to reduce the amount of signaling in beam control and/or positioning. The LMF may learn encoding/decoding of information used for positioning. The LMF may notify the base station and/or the UE of information about the encoding model/decoding model that have been learned. Consequently, for example, it is possible to avoid complexity regarding a positioning process.

The method disclosed in the present embodiment may be applied to minimization of drive tests (MDT) (Non Patent Literature 35 (3GPP TS 37.320)). Encoding/decoding may be used for transmission of a measurement result of the MDT from the UE to the base station. The learning device may be included in the base station or the core NW device. The base station may notify the UE of the learned model. As another example, the core NW device may transmit the learned model to the base station and/or the UE. The UE may encode the measurement result of the MDT by using the information. The base station may decode the encoded measurement result received from the UE by using the information. Consequently, for example, it is possible to improve efficiency in a notification of information about the measurement result of the MDT.

According to the first embodiment, the CSI report can be encoded/decoded between the base station and the UE, and as a result, the size of the CSI report can be reduced.

### First Modification of First Embodiment.

The following problem occurs in transmission between the base station and the UE using the encoding model/decoding model. That is, information transmitted and received between the base station and the UE differs depending on the operation phase of the encoding model/decoding model. For example, in a case where the operation phase is the learning phase, un-encoded data is transmitted and received, and in a case where the operation phase is the inference phase, encoded data is transmitted and received.

Therefore, in a case where the operation phase recognized by the UE is different from the operation phase recognized by the base station, transmission and reception between the base station and the UE are not correctly performed, and as a result, malfunction occurs in the communication system, which is a problem.

The first modification discloses a method for solving the above problem.

That is, in the communication system according to the first modification, the base station notifies the UE of information about the phase of the learning device. The information may be, for example, information about phase switching. The base station may notify the UE of information about phase switching of the learning device.

The phase may be the inference phase, the learning phase, or the phase of the normal operation described above.

The notification from the base station to the UE may be performed for each learning device. For example, a notification of operation phase switching of the learning device for the encoding/decoding models of the CSI report and a notification of operation phase switching of the learning device for the encoding/decoding models of a beam measurement result notification may be performed by using different signalings.

As another example, one signaling may include the notification about a plurality of learning devices. For example, the operation phase of the learning device for the encoding/decoding models of the CSI report and the operation phase of the learning device for the encoding/decoding models of the beam measurement result notification may be included in one signaling. Consequently, for example, it is possible to reduce signaling between the base station and the UE.

RRC signaling may be used for the notification from the base station to the UE. Consequently, for example, it is possible for the base station to notify the UE of a lot of information. As another example, MAC signaling may be used. Consequently, for example, it is possible for the base station to promptly perform the notification to the UE. As another example, L1/L2 signaling may be used. Consequently, for example, it is possible for the base station to more promptly perform the notification to the UE.

The UE may start or stop encoding the information as triggered by the notification. As another example, the UE may transmit the learning data to the base station as triggered by the notification. For example, the learning data may be transmitted to the base station as triggered by a notification of stop of operation of the encoding/decoding models from the base station. Consequently, for example, the UE can promptly transmit the learning data to the base station.

A learning data transmission instruction may be an instruction to stop the encoding. For example, the UE may stop the encoding of the CSI as triggered by the reception of the learning data transmission instruction. Consequently, for example, it is possible to reduce the amount of signaling from the base station to the UE.

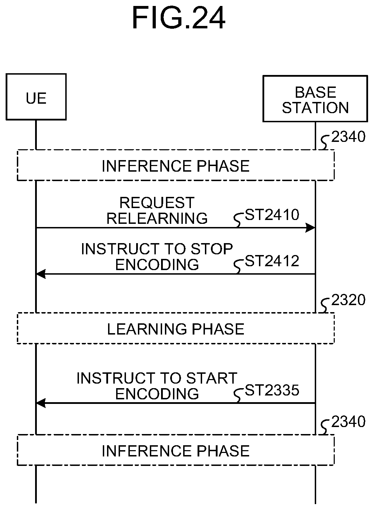

FIG. 24 is a sequence diagram illustrating an example of switching of the operation phases of the encoding/decoding models of the CSI report. FIG. 24 illustrates an example in which the operation phase of the encoding/decoding models is switched in the order of the inference phase, the learning phase, and the inference phase. In FIG. 24, processes similar to those in FIG. 23 are denoted by the same numbers as those therein, and a common description will be omitted.

In procedure 2340 illustrated in FIG. 24, the inference phase of the encoding/decoding models is performed. The operation in the inference phase is similar to that in FIG. 23.

Suppose that relearning becomes required during execution of procedure 2340 in the example illustrated in FIG. 24. That is, suppose that a predetermined relearning condition is satisfied. In that case, in step ST2410, the UE requests the base station to execute relearning. RRC signaling, MAC signaling, or L1/L2 signaling may be used for the request. In step ST2412, the base station instructs the UE to stop the encoding. RRC signaling, MAC signaling, or L1/L2 signaling may be used for the instruction.

In procedure 2320 illustrated in FIG. 24, the learning phase of the encoding/decoding models is performed. The operation in the learning phase is similar to that in FIG. 23.

Step ST2335 illustrated in FIG. 24 is similar to that in FIG. 23.

In procedure 2340 subsequent to step ST2335 illustrated in FIG. 24, the inference phase of the encoding/decoding models is performed. The operation in the inference phase is similar to that in FIG. 23.

The signaling of step ST2412 illustrated in FIG. 24 need not be transmitted. For example, the UE may autonomously stop the encoding as triggered by signaling transmission in step ST2410. The base station may recognize that the UE has stopped the encoding or may stop the decoding process as triggered by the reception in step ST2410. Consequently, for example, it is possible to reduce the amount of signaling between the base station and the UE.

Step ST2335 illustrated in FIG. 24 need not be transmitted to the UE. For example, step ST2335 may be included in step ST2329 in FIG. 23. Consequently, for example, the UE can promptly start the encoding.

According to the first modification, inconsistency in recognition about the operation phase of the encoding model/decoding model between the base station and the UE can be prevented, and as a result, malfunction in the communication system can be prevented.

### Second Embodiment.

Regarding the encoding model/decoding model used by the base station and/or the UE, there is the following problem. That is, depending on the performance of the UE, there is a possibility that the encoding model learned by the base station cannot be used. There arises a problem in that, for example, in a case where a memory of the UE is small or a calculation processing speed in the UE is slow, the encoding model cannot be used.

The second embodiment discloses a method for solving the above problem.

That is, in the communication system according to the second embodiment, the UE notifies the base station of information about availability of the learning device. The UE may notify the base station of information about a capability of the learning device. The above information may be included in UE capability. The UE may notify the base station of the UE capability including the information, or may notify the core NW device, for example, the AMF thereof. With the use of the information, the base station may determine whether to use the encoding model/decoding model between the UE and the base station, or may determine the encoding model to be used. The determination may be made by the core NW device, for example, the AMF.

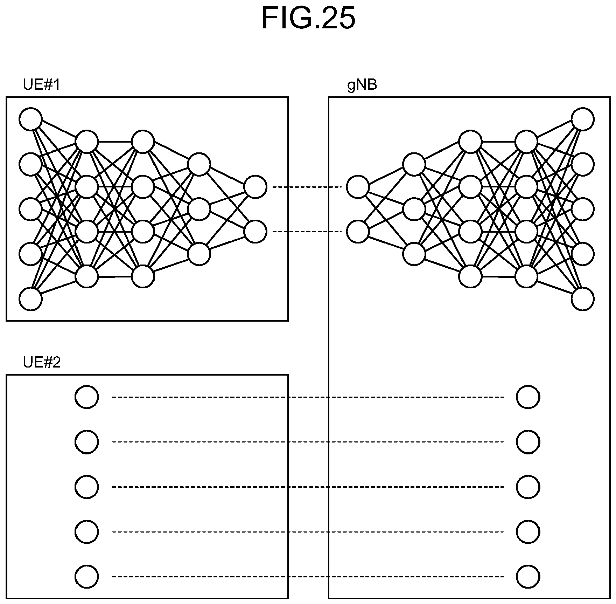

FIG. 25 is a diagram illustrating an example of communication between a base station and a UE that can use the encoding/decoding models and a UE that cannot use the encoding/decoding models. FIG. 25 illustrates an example in which UE #1 is the UE that can use the encoding/decoding models and UE #2 is the UE that cannot use the encoding/decoding models. In the example illustrated in FIG. 25, encoding/decoding of the CSI report are performed by using the encoding model/decoding model between the base station and UE #1, and the encoding model/decoding model are not configured and the CSI report is transmitted and received as it is between the base station and UE #2.

A capability of the encoding/decoding models used between the UE and the base station may be categorized. The UE may notify the base station of information about the capability of the encoding/decoding models. The base station may categorize the encoding/decoding models using the information from the UE. With the use of information about the category of the encoding/decoding models of the UE, the base station may determine the encoding/decoding models to be used. Consequently, for example, the base station can promptly determine the encoding/decoding models to be used.

As another example, the UE may notify the base station of information about the category of the encoding/decoding models. The notification may be performed by including the information in the UE capability, for example. With the use of the information from the UE, the base station may determine the encoding/decoding models to be used. Consequently, for example, the base station can more promptly determine the encoding/decoding models to be used.

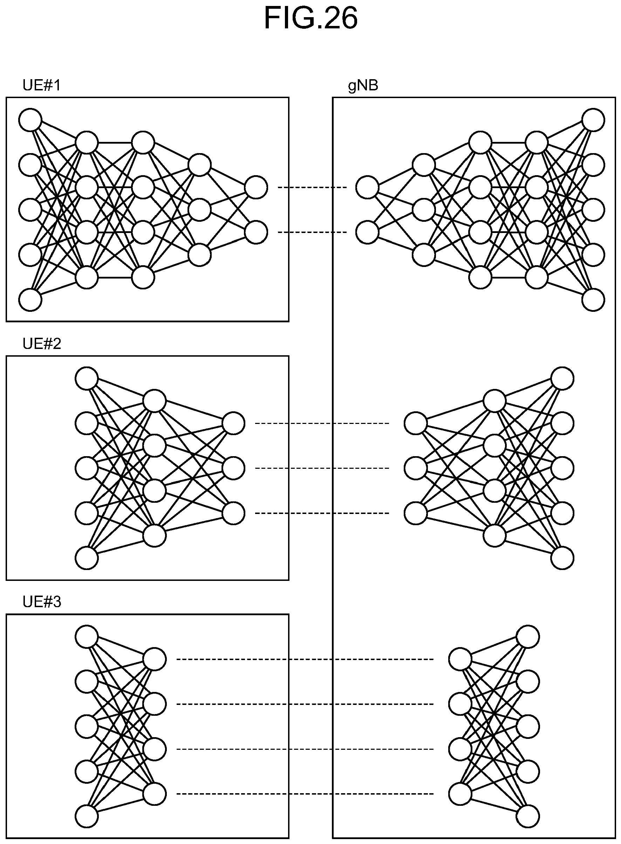

FIG. 26 is a diagram illustrating an example of communication between the base station and UEs having different categories of encoding/decoding models. FIG. 26 illustrates an example in which UE #1, UE #2, and UE #3 have encoding/decoding models of which capabilities are different from each other. In the example illustrated in FIG. 26, encoding/decoding of CSI reports between the base station and UE #1, between the base station and UE #2, and between the base station and UE #3 are performed by using encoding models/decoding models different from each other.

The following (A) to (M) will be disclosed as examples of the information about the capability of the encoding/decoding models which the UE notifies the base station of.
(A) The maximum number of nodes.
(B) The maximum number of input layers.
(C) The maximum number of hidden layers.
(D) The maximum number of depths of the hidden layer.
(E) The maximum number of output layers.
(F) Applicability of functions to the hidden layer and/or the output layer.
(G) Maximum precision of values of nodes.
(H) The maximum number of branches.
(I) Maximum precision of weight values of branches.
(J) Processing speed of the UE.
(K) A memory amount of the learning device of the UE.
(L) Information about the category of the learning device of the UE.
(M) A combination of the above (A) to (L).

The above (A) may be, for example, the maximum number of nodes itself in the input layer, the hidden layer, and the output layer, in total, or an identifier indicating the maximum number of nodes. The association between the maximum number of nodes and the identifier may be determined in advance in a standard, may be determined by the base station and the base station may notify the UE thereof, or may be determined by the core NW device (e.g., AMF) and the core NW device may notify the base station and/or the UE thereof. The base station may determine the size of the encoding model by using the information. Consequently, for example, memory overflow in the UE can be prevented, and as a result, malfunction of the UE can be prevented.

The above (B) may include information about the maximum number of nodes in the input layer. An identifier indicating the maximum number of nodes may be used instead of the information about the maximum number of nodes itself. The association between the maximum number of nodes and the identifier may be determined in advance in a standard, may be determined by the base station and the base station may notify the UE thereof, or may be determined by the core NW device (e.g., AMF) and the core NW device may notify the base station and/or the UE thereof. The base station may configure the input layer of the encoding model by using the information. Consequently, for example, the base station can construct an encoding model usable in the UE, as well.

The above (C) may include information about the maximum number of nodes in the entirety of the hidden layers. An identifier indicating the maximum number of nodes may be used instead of the information about the maximum number of nodes itself. The association between the maximum number of nodes in the hidden layers and the identifier may be determined in advance in a standard, may be determined by the base station and the base station may notify the UE thereof, or may be determined by the core NW device (e.g., AMF) and the core NW device may notify the base station and/or the UE thereof. The base station may configure the hidden layers of the encoding model by using the information. Consequently, for example, the base station can construct an encoding model usable in the UE, as well.

The above (D) may be information about the maximum number of depths of the hidden layer in the encoding unit. The base station may construct the hidden layer by using the information. Consequently, for example, an effect similar to that described above is obtained.

The above (E) may include information about the maximum number of nodes in the output layer. An identifier indicating the maximum number of nodes may be used instead of the information about the maximum number of nodes itself. The association between the maximum number of nodes in the output layer and the identifier may be determined in advance in a standard, may be determined by the base station and the base station may notify the UE thereof, or may be determined by the core NW device (e.g., AMF) and the core NW device may notify the base station and/or the UE thereof. The base station may configure the output layer of the encoding model by using the information. Consequently, for example, it is possible to construct the encoding model in the UE.

The above (F) may include information about a function applicable to an input value of each hidden layer and/or the output layer. The function may be, for example, a sigmoid function, a hyperbolic tangent function, or a linear function. Applicability may be given for each function. The base station may determine a function to be applied to the encoding model by using the information. By the information of the above (F), for example, the base station can construct the encoding model executable in the UE.

For example, the information about the above (G) may be given as the number of bits, or may be given as a value type (e.g., single precision real number, or double precision real number). The compatibility of each value type may be given. The base station may determine the accuracy of values of nodes by using the information. Consequently, for example, memory overflow in the UE can be prevented, and as a result, malfunction in the UE can be prevented.

The above (H) may include information about the maximum number of branches usable in the encoding model. The above (H) may be an identifier indicating the maximum number of branches. The association between the maximum number of branches and the identifier may be determined in advance in a standard, may be determined by the base station and the base station may notify the UE thereof, or may be determined by the core NW device (e.g., AMF) and the core NW device may notify the base station and/or the UE thereof. The base station may determine the size of the encoding model by using the information. Consequently, for example, memory overflow in the UE can be prevented, and as a result, malfunction of the UE can be prevented.

The information about the above (I) may be given similarly to the above (G), for example. Consequently, for example, an effect similar to that of the above (G) is obtained.

The above (J) may include information about a calculation speed of an encoding process performed by the UE. The base station may determine the size of the encoding model by using the information. The base station may use, for the determination, an encoding processing time allowed in the UE. Consequently, for example, it is possible to prevent malfunction due to a delay of the encoding process performed by the UE.

The above (K) may be a memory amount itself usable for the encoding process or an identifier indicating the memory amount. The association between the memory amount and the identifier may be determined in advance in a standard, may be determined by the base station and the base station may notify the UE thereof, or may be determined by the core NW device (e.g., AMF) and the core NW device may notify the base station and/or the UE thereof. The base station may determine the size of the encoding model by using the information. Consequently, for example, memory overflow in the UE can be prevented, and as a result, malfunction of the UE can be prevented.

The above (L) may be, for example, information indicating the size of the encoding model usable by the UE. The base station may determine the size of the encoding model by using the information. Consequently, for example, the amount of signaling between the base station and the UE can be reduced, and the base station can promptly determine the encoding model.

According to the second embodiment, the base station can perform transmission and reception using the encoding/decoding models to and from UEs having different capabilities, as well.

First Modification of Second Embodiment.

In the second embodiment, the encoding model/decoding model for each capability of the learning device of the UE have been disclosed. However, an application range of the encoding model/decoding model has not been disclosed. As a result, there arises a problem in that inconsistency in the encoding model/decoding model occurs, for example, in communication between a plurality of UEs and the base station, which results in malfunction occurring in the communication system.

The first modification discloses a method for solving the above problem.

That is, in the communication system according to the first modification, the encoding model/decoding model may be provided for each UE. The base station may have the encoding model/decoding model for each UE. Consequently, for example, an optimal learning result is obtained on the basis of the channel state of the UE or the like, and as a result, it is possible to reduce the size of signaling for notification from the UE to the base station.

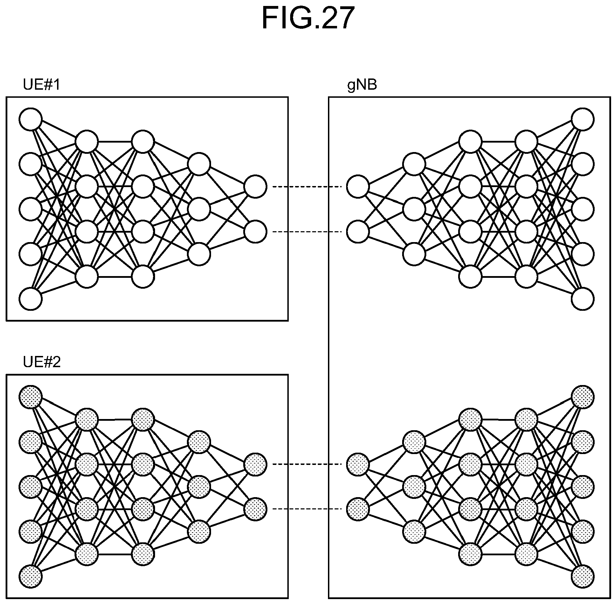

FIG. 27 is a diagram illustrating an example of a case where the encoding model/decoding model are provided for each UE. In FIG. 27, the base station has encoding model/decoding model for UE #1 and encoding model/decoding model for UE #2.

Another solution will be disclosed. The encoding model/decoding model may be provided to be shared between different UEs. Consequently, for example, it is possible to reduce the amount of processing of the base station, and to reduce memory usage of the base station.

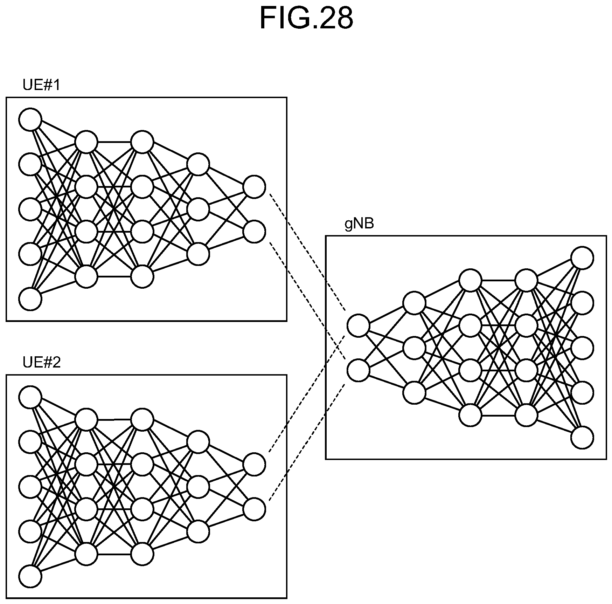

FIG. 28 is a diagram illustrating an example of a case where the encoding model/decoding model are provided to be shared between different UEs. In FIG. 28, the base station has encoding model/decoding model for UE #1 and UE #2, which are common thereto.

As an example in which the encoding model/decoding model are provided to be shared between different UEs, the encoding model/decoding model may be provided for each of categories of the learning devices of the UEs disclosed in the second embodiment. Consequently, for example, it is possible to reduce the memory usage of the base station while enabling transmission and reception using the encoding/decoding models to and from UEs having different capabilities to be performed.

As another example, a group of UEs using the same encoding model/decoding model may be provided. The group may include, for example, UEs having similar channel states between the base station and the UEs. Consequently, for example, an optimal learning result is obtained on the basis of the channel state for each group or the like, and as a result, it is possible to reduce the size of signaling for notification from the UE to the base station and to reduce the memory usage of the base station. As another example pertaining to the group, the group may include UEs with the same or similar QoS requirements. Consequently, for example, it is possible to achieve the QoS requirements of the UEs with a small memory amount.

The base station may determine a group to which a UE belongs. The base station may determine the group to which the UE belongs by using, for example, a CSI report from the UE. The base station may notify the UE of information about the group to which the UE belongs. RRC signaling, MAC signaling, or L1/L2 signaling may be used for the notification. For example, the information may be included in the notification of the encoding model from the base station to the UE disclosed in the first embodiment. The UE may know the group to which the UE belongs by using the information.

The group to which the UE belongs may be changed. The change may be determined by the base station. The base station may determine the change of the group to which the UE belongs by using, for example, the CSI report from the UE. For example, in a case where a channel state between the base station and the UE suddenly changes, the group may be changed. The base station may notify the UE of information about the change of the group to which the UE belongs. RRC signaling, MAC signaling, or L1/L2 signaling may be used for the notification. The notification from the base station to the UE may include information about the encoding model used in the group after the change.

The base station may notify the UE of information about encoding models of a plurality of groups in advance. Information about a plurality of the models may be determined in advance in a standard. Consequently, for example, it is possible to promptly respond to changes in the channel state between the base station and the UE.

The learning of the encoding model/decoding model may be performed simultaneously for all UEs belonging to the group (hereinafter, sometimes referred to as intra-group UEs). For example, the base station may instruct the intra-group UEs to stop the encoding as triggered by a relearning request from a certain UE in the group. The intra-group UEs may each transmit an un-encoded CSI report to the base station as triggered by the instruction. The base station may notify the intra-group UEs of the information about the encoding model after relearning. The intra-group UEs may each update the encoding model by using the notification. The base station may instruct the intra-group UEs to start encoding. The intra-group UEs may each resume the encoding of the CSI report as triggered by the instruction. Consequently, for example, it is possible to avoid complexity in the communication system.

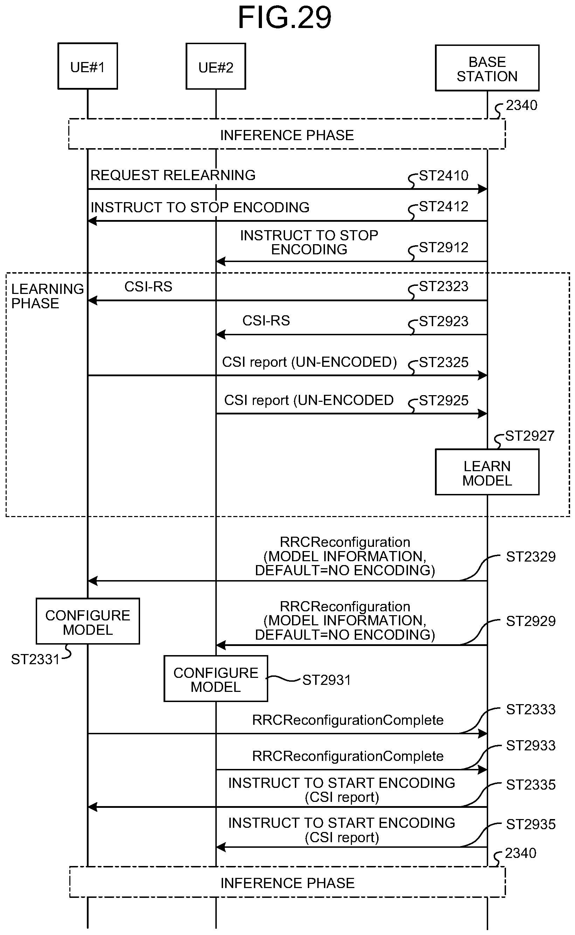

FIG. 29 is a sequence diagram illustrating an operation in a case where learning of the encoding model/decoding model is performed simultaneously for all UEs belonging to the group. In the example illustrated in FIG. 29, UE #1 and UE #2 belong to the same group. In the example illustrated in FIG. 29, UE #1 requests the base station to execute relearning. In FIG. 29, processes similar to those in FIGS. 23 and 24 are denoted by the same numbers as those therein, and a common description will be omitted.

In procedure 2340 illustrated in FIG. 29, processes similar to those in the inference phase of procedure 2340 illustrated in FIG. 23 are performed between the base station and the UE #1 and between the base station and the UE #2. In steps ST2410 and ST2412, processes similar to those in FIG. 24 are performed between the base station and UE #1.

In step ST2912 illustrated in FIG. 29, the base station instructs the UE #2 to stop the encoding. For the instruction, signaling similar to that in step ST2412 may be used.

A broken line part illustrated in FIG. 29 indicates the learning phase.

In steps ST2323 and ST2325 illustrated in FIG. 29, processes similar to those in FIG. 23 are performed between the base station and UE #1. In steps ST2923 and ST2925, processes similar to those in steps ST2323 and ST2325, respectively, are performed between the base station and UE #2. In step ST2927, the base station learns the encoding/decoding models of the CSI report. The CSI report in step ST2325, the CSI report in step ST2925, or both of the above may be used for the learning.

In steps ST2329, ST2331, ST2333, and ST2335 illustrated in FIG. 29, processes similar to those in FIG. 23 are performed between the base station and UE #1. In steps ST2929, ST2931, ST2933, and ST2935, processes similar to those in steps ST2329, ST2331, ST2333, and ST2335 are performed between the base station and UE #2.

In procedure 2340 subsequent to step ST2935 illustrated in FIG. 29, processes similar to those in the inference phase of procedure 2340 illustrated in FIG. 23 are performed between the base station and the UE #1 and between the base station and the UE #2.

The same encoding model/decoding model may be used in a plurality of different groups. The plurality of different groups may have used different encoding models/decoding models before using the same encoding model/decoding model, or may use different encoding models/decoding models after using the same encoding model/decoding model. Consequently, for example, it is possible to reduce the memory usage of the base station.

The learning of the encoding model/decoding model may be performed only for one or some of UEs belonging to the group (hereinafter, sometimes referred to as specific UE). That is, both a UE that transmits an un-encoded CSI report and a UE that transmits an encoded CSI report may be present in the same group. Consequently, for example, it is possible to reduce the size of signaling between the base station and the UEs.

For example, the base station may instruct the specific UE to stop the encoding as triggered by a relearning request from the specific UE. The specific UE may transmit an un-encoded CSI report to the base station as triggered by the instruction. The base station need not instruct another UE in the group (hereinafter, sometimes referred to as the other UE) to stop the encoding. The other UE may continue to encode the CSI report and to transmit the encoded CSI report to the base station. The base station may relearn the encoding model/decoding model by using the un-encoded CSI report from the specific UE, and may decode the encoded CSI report from the other UE. The base station may include the learning device 810 illustrated in FIG. 14 and the inference device 860 illustrated in FIG. 20 as devices different from each other. The base station may use the learning device for relearning and the inference device for decoding.

For example, the base station may instruct the specific UE to stop the encoding as triggered by the relearning request from the specific UE. The specific UE may transmit the un-encoded CSI report to the base station as triggered by the instruction. The base station need not instruct the other UE to stop the encoding. The other UE may transmit the encoded CSI report to the base station.

The base station may notify the intra-group UEs of the information about the encoding model after relearning. The intra-group UEs may each update the encoding model by using the notification.

The other UE may autonomously stop the encoding of the CSI report as triggered by the notification. As another example, the base station may explicitly instruct the other UE to stop the encoding.

The base station may instruct the intra-group UEs to start encoding. The intra-group UEs may each resume the encoding of the CSI report as triggered by the instruction.

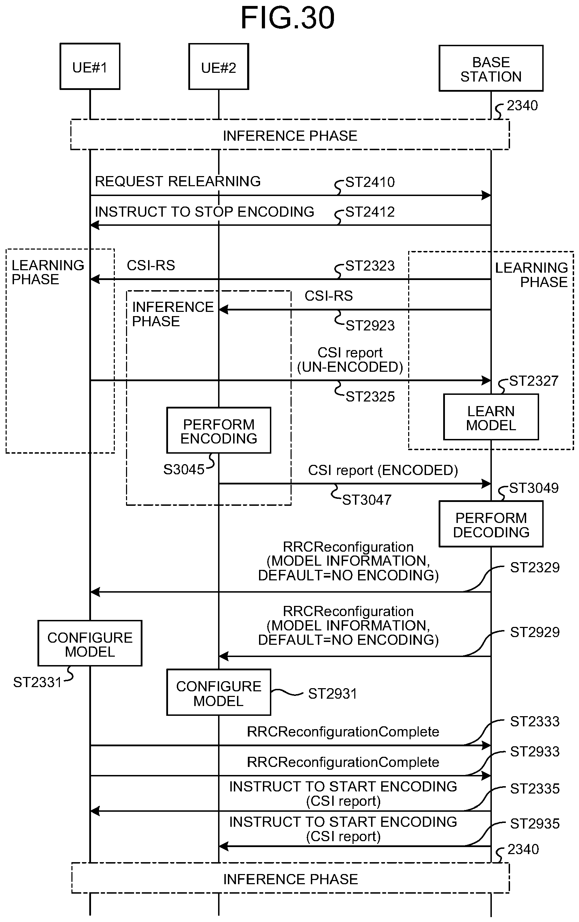

FIG. 30 is a sequence diagram illustrating an operation in a case where learning of the encoding model/decoding model is performed only for one or some of UEs belonging to the group. In the example illustrated in FIG. 30, UE #1 and UE #2 belong to the same group. In the example illustrated in FIG. 30, UE #1 requests the base station to execute relearning. In FIG. 30, processes similar to those in FIGS. 23, 24, and 29 are denoted by the same numbers as those therein, and a common description will be omitted.

In procedure 2340 illustrated in FIG. 30, processes similar to those in the inference phase of procedure 2340 illustrated in FIG. 23 are performed between the base station and the UE #1 and between the base station and the UE #2. In steps ST2410 and ST2412, processes similar to those in FIG. 24 are performed between the base station and UE #1.

In FIG. 30, unlike FIG. 29, the instruction to stop the encoding is not given to UE #2.

In steps ST2323 and ST2325 illustrated in FIG. 30, processes similar to those in FIG. 23 are performed between the base station and UE #1. In step ST2923, a process similar to that in step ST2323 is performed between the base station and UE #2. In steps ST3045, ST3047, and ST3049, processes similar to those in steps ST2345, ST2347, and ST2349 in FIG. 23 are performed between the base station and UE #2. The base station may have encoding/decoding models for learning and encoding/decoding models for inference (for execution).

In steps ST2329, ST2331, ST2333, and ST2335 illustrated in FIG. 30, processes similar to those in FIG. 23 are performed between the base station and UE #1. In steps ST2929, ST2931, ST2933, and ST2935, processes similar to those in steps ST2329, ST2331, ST2333, and ST2335 are performed between the base station and UE #2.

One UE may use a plurality of encoding models. For example, an encoding model different for each cell may be used. The encoding model different for each cell may be used, for example, in CA. Consequently, for example, encoding model/decoding model based on the channel state in each cell can be learned, and as a result, overhead of communication between the base station and the UE can be reduced.

As another example, a cell-common encoding model may be used. The cell-common encoding model may be used, for example, in CA. Consequently, for example, it is possible to reduce the memory usage of the UE.

As another example, an encoding model different for each BWP may be used. Consequently, for example, encoding model/decoding model based on the channel state in each BWP can be learned, and as a result, overhead of communication between the base station and the UE can be reduced.

As another example, an encoding model different for each service may be used, or an encoding model different for each QoS may be used. As an example of the encoding model different for each service, different encoding models may be used in multicast and unicast, or different encoding models may be used in broadcast, groupcast, and unicast. Consequently, for example, the encoding model/decoding model suitable for each service can be learned, and as a result, overhead of communication between the base station and the UE can be reduced.

The same encoding model/decoding model may be used in a master base station (master node: MN) and a secondary base station (secondary node: SN). For example, the SN may use the same encoding model/decoding model as the MN. Consequently, for example, encoding/decoding between the UE and the SN can be promptly started, and as a result, the size of signaling between the UE and the SN can be reduced. The MN may notify the SN of the encoding model/decoding model. The MN may notify the SN of information about the learning device of the UE. The notification may be performed by including the information about the learning device of the UE in the UE capability, for example. The above notification may be performed by using, for example, an Xn interface. The above notification may be included in, for example, signaling of SN Addition or signaling of SN Modification Request.

As another example, the MN may use the same encoding model/decoding model as the SN. The MN may notify the SN of the information about the learning device of the UE. The notification may be performed by including the information about the learning device of the UE in the UE capability, for example. The SN may notify the MN of the encoding model/decoding model. The MN may modify the encoding model/decoding model of the base station, i.e., the MN, by using the encoding model/decoding model which the SN has notified the MN of. Consequently, for example, memory usage of the UE can be prevented from increasing, and the encoding model/decoding model based on the latest channel state can be used, and as a result, reliability regarding notification of the encoded CSI report can be improved. The above notification may be performed by using, for example, an Xn interface. The above notification may be included, for example, in signaling of SN Modification Required.

As another example, different encoding models/decoding models may be used in the master base station (master node: MN) and the secondary base station (secondary node: SN). Consequently, for example, encoding model/decoding model based on the channel state between each base station and the UE can be learned, and as a result, overhead of communication between each base station and the UE can be reduced.

In a case where the UE moves between base stations, a source base station and a destination base station may use the same encoding model/decoding model. The above operations may be used in handover, for example. Consequently, for example, encoding/decoding between the UE and the destination base station can be promptly started, and as a result, the size of signaling between the UE and the destination base station can be reduced. The source base station may notify the destination base station of the information about the learning device of the UE. The notification may be included in the UE capability, for example, and performed. The source base station may notify the destination base station of information about the encoding model/decoding model. The notification may be performed by using, for example, an Xn interface. The notification may be performed by using, for example, signaling of Handover Request.

In a case where the UE moves between base stations, the source base station and the destination base station may use different encoding models/decoding models. Consequently, for example, encoding model/decoding model based on the latest channel state between the UE and the destination base station can be used, and as a result, reliability regarding notification of the encoded CSI report can be improved. The source base station may notify the destination base station of the information about the learning device of the UE. The notification may be included in the UE capability, for example, and performed. The source base station may notify the destination base station of information about a result of measurement by the UE. The information may include information about a result of reception by the UE of a signal from the destination base station. The signal may be, for example, a CSI-RS. The notification from the source base station to the destination base station may be performed by using, for example, signaling of Handover Request. The destination base station may learn the encoding model/decoding model between the UE and the destination base station by using the notification. The destination base station may notify the source base station of information about the encoding model/decoding model that have been learned. For the notification from the destination base station to the source base station, for example, Handover Request Acknowledge may be used. The source base station may notify the UE of information about the encoding model/decoding model in the destination base station. For example, RRCReconfiguration may be used for the notification. Consequently, for example, encoding/decoding between the UE and the destination base station can be promptly started, and as a result, the size of signaling between the UE and the destination base station can be reduced.

The use of the same encoding model/decoding model between the source base station and the destination base station may be applied to handover using a dual active protocol stack (DAPS). Consequently, for example, it is possible to reduce the memory usage of the UE.

The use of different encoding models/decoding models between the source base station and the destination base station may be applied to handover using DAPS. Consequently, for example, reliability regarding transmission and reception of the encoded CSI report between the UE and both base stations can be improved.

According to the first modification, for example, in a case where the encoding model/decoding model are shared, memory usage of the communication system can be reduced. In addition, in a case where the encoding models/decoding models are individually provided, encoding model/decoding model based on the channel state between the UE and the base station can be used, and as a result, reliability regarding notification of the encoded CSI report can be improved.

### Third Embodiment.

In the process of learning in a communication system or as a result thereof, there may be a case where input data becomes no longer required. For example, in a case where a weighting coefficient of a branch connected to a node to which the data is input is negligibly small as compared with weighting coefficients of other branches in the learning device, the input of the data is no longer required. In addition, there may arise a case where input data is required anew.

The following problems occur in machine learning in the communication system. That is, in a case where a device as a data input source (for example, a UE) is different from a learning device (for example, a base station), the device as the data input source does not know the input data that is no longer required and/or the input data that is required anew in the learning device. Therefore, the device as the data input source continues to send the input data that is no longer required to the learning device or does not send the input data that is required anew to the learning device, which causes a problem in that communication efficiency between the device as the data input source and the learning device is reduced or appropriate learning by the learning device cannot be performed.

The third embodiment discloses a method for solving the above problem.

That is, in the communication system according to the third embodiment, the learning device, for example, the base station notifies the device as the data input source, for example, the UE of information about the input data. A notification of information about data to be a candidate for the input data may be performed. The information may include, for example, an identifier indicating the type of data, or information about whether there is transmission of the data in an initial state. For example, RRC signaling may be used for the notification. Consequently, for example, it is possible for the base station to notify the UE of a lot of information. As another example, MAC signaling may be used. Consequently, for example, it is possible to promptly perform the notification. As another example, L1/L2 signaling may be used. Consequently, for example, it is possible to more promptly perform the notification.

The information about the input data may include information about the type of CSI-RS to be measured. The information may be, for example, a zero-power CSI-RS (ZP-CSI-RS) or a non-zero power CSI-RS (NZP-CSI-RS) (see Non Patent Literature 13 (3GPP TS 38.211)), or channel state information-interference measurement (CSI-IM) (see Non Patent Literature 15 (3GPP TS 38.214)). Consequently, for example, it is possible to improve the flexibility of channel measurement.

The base station notifies the UE of information about the input data that is no longer required and/or the input data that is now required. A notification of information about change of required input data may be performed. The information may include an identifier of the input data that is no longer required and/or the input data that is now required, may include the number of pieces of the input data that are no longer required, or may include the number of pieces of the input data that are now required. Information about on/off of transmission of data to be a candidate for input data may be included. For example, RRC signaling may be used for the notification. Consequently, for example, it is possible for the base station to notify the UE of a lot of information. As another example, MAC signaling may be used. Consequently, for example, it is possible to promptly perform the notification. As another example, L1/L2 signaling may be used. Consequently, for example, it is possible to more promptly perform the notification.

The UE may transmit, to the base station, input data required by the base station as triggered by the notification. The UE may transmit information indicating that the data is learning data. Consequently, for example, the base station can promptly know that the data is learning data. The transmission may be performed by using the C-plane or a user plane (hereinafter, referred to as U-plane). For example, the UE may use the U-plane for transmission of learning data (e.g., data regarding the orientation of the UE, a magnetic sensor, an acceleration sensor, a speed sensor, radar, and camera images) from the application layer.

The method disclosed in the present embodiment may be used for channel estimation. For example, the method may be used for feedback of a downlink signal. For example, the method may be used for notification of whether target resources (time, a frequency, and an antenna port) of the CSI report are required. As another example, the method may be used for transmission of an uplink signal. For example, the method may be used for notification of whether resources (time, a frequency, and an antenna port) of an uplink DM-RS and/or an SRS are required. The UE may use the information to change the resources of the DM-RS and/or the SRS to be transmitted.

The following (a) to (h) will be disclosed as information on resources of the uplink signal.
(a) Type of RS.
(b) Information about a subcarrier.
(c) Information about a symbol.
(d) Information about a subframe.
(e) Information about a period and an offset.
(f) Information about a code sequence.
(g) Information about an antenna port.
(h) A combination of (a) to (g) described above.

The above (a) may be, for example, information indicating that the type is DM-RS or information indicating that the type is SRS. Consequently, for example, the resources can be flexibly changed.

The above (b) may be provided, for example, on a one-subcarrier basis, on a multiple-subcarrier basis, or on a PRB basis. As another example, the above (b) may be information about a range of frequencies in which the RS is transmitted. Consequently, for example, the frequency resource for transmitting the RS can be flexibly controlled.

The above (c) may be, for example, information about a symbol in which the RS is to be transmitted or not to be transmitted. Consequently, for example, the time resource for transmitting the RS can be controlled on a symbol basis, and as a result, flexibility of the communication system can be improved.

The above (d) may be, for example, information about a subframe in which the RS is to be transmitted or not to be transmitted. Consequently, for example, the time resource for transmitting the RS can be controlled on a subframe basis, and as a result, flexibility of the communication system can be improved.

The above (e) may be, for example, information about a period of the RS to be transmitted or not to be transmitted, or information about an offset with respect to the period. Consequently, for example, the time resource for transmitting the RS can be flexibly controlled.

The above (f) may be, for example, information about a code sequence of the RS to be transmitted or not to be transmitted. Consequently, for example, it is possible to improve flexibility of control of the RS.

The above (g) may be, for example, information about an antenna port of the RS to be transmitted or not to be transmitted. Consequently, for example, it is possible to improve flexibility of control of the spatial resource of the RS.

The information disclosed as (a) to (h) may be used in a downlink signal report. Consequently, for example, an effect similar to that in transmission of the uplink signal is obtained.

The base station need not transmit a downlink signal that does not require a downlink signal report from the UE. For example, the base station need not transmit a CSI-RS that does not require the CSI report from the UE. The base station may notify the UE that the CSI-RS is not transmitted. For the notification of the information, RRC signaling (e.g., RRCReconfiguration) may be used, or MAC signaling or L1/L2 signaling may be used. With the use of the information, the UE need not receive the CSI-RS that does not require the CSI report. Consequently, for example, it is possible to improve the efficiency of the communication system.

The method disclosed in the third embodiment may be applied to minimization of drive tests (MDT) (Non Patent Literature 35 (3GPP TS 37.320)). The base station may notify the UE of information indicating that transmission of some information on measurement results of the MDT is not required. The notification may be performed from the core NW device, for example, the AMF, to the UE. With the use of the notification, the UE need not notify the base station of some information as the information not required, need not store the information, or may discard the information that has been stored. Consequently, for example, it is possible to reduce the memory usage of the UE.

According to the third embodiment, transmission of unrequired learning data from the UE to the base station can be prevented, and as a result, the efficiency of the communication system can be improved.

### Fourth Embodiment.

Regarding a learning result in the communication system, feedback may be performed from the inference device to the learning device. The learning device may determine whether to perform relearning as triggered by the feedback.

However, a specific method of feedback on a learning model from the inference device to the learning device is not disclosed. Therefore, there arises a problem in that the feedback on the learning model cannot be performed in the communication system, and as a result, relearning cannot be performed.

The fourth embodiment discloses a method for solving the above problem.

That is, in the communication system according to the fourth embodiment, the inference device, for example, the UE notifies the learning device, for example, the base station of information about feedback of a result of inference. For example, the UE performs a notification of information indicating whether scheduling after transmission of the CSI report meets expectations of the UE. The UE may perform the notification to the base station only in a case where scheduling after transmission of the CSI report does not meet the expectations of the UE. Consequently, for example, it is possible to reduce overhead in the communication system. As another example, the UE may periodically perform the feedback. Consequently, for example, it is possible to avoid complexity in the communication system.

Examples of the case where the scheduling after the transmission of the CSI report does not meet the expectation of the UE may be: a case where scheduling for decreasing an encoding rate is performed after transmission of a CSI report indicating that the channel state is bad, a case where many transport data transmissions are allocated after the above transmission, and/or a case where an instruction to decrease transmission power is given after the above transmission; or a case where scheduling for increasing the encoding rate is performed after transmission of a CSI report indicating that the channel state is good, a case where few transport data transmissions are allocated after the above transmission, and/or a case where an instruction to increase the transmission power is given after the above transmission.

The case where scheduling for increasing the encoding rate is performed after the transmission of the CSI report indicating that the channel state is good and/or the case where few transport data transmissions are allocated after the above transmission may be excluded from the examples of the case where the scheduling after the transmission of the CSI report does not meet the expectations of the UE. Consequently, for example, a case where there is little or no data to be transmitted from the base station can be excluded from the case where the expectations of the UE are not met, and as a result, it is possible to prevent malfunction in the communication system.

As another example, the UE may notify the base station of information about success or failure of beam control. The UE may notify the base station of only the information about failure of the beam control. Consequently, for example, it is possible to reduce overhead in the communication system. The UE may determine that the beam control has failed, for example, in a case where the quality of a beam transmitted from the base station deteriorates. As the quality of the beam, reference signal receive power (RSRP) may be used, reference signal receive quality (RSRQ) may be used, or SNR or SINR may be used.

As another example, the UE may notify the base station of information about success or failure of positioning. The UE may notify the base station of only the information about failure of the positioning. Consequently, for example, it is possible to reduce overhead in the communication system. The UE may determine that the positioning has failed, for example, in a case where a result of the positioning that has been obtained is significantly different from a result of the positioning obtained by another method (e.g., a global navigation satellite system (GNSS)) (for example, in a case where an error equal to or larger than a predetermined threshold has occurred).

As another example, the UE may notify the base station of information about degradation in radio performance caused by not receiving RSs from the base station. The information may include, for example, a decrease in BER, a decrease in block error ratio (BLER), or out-of-synchronization.

For example, RRC signaling may be used for the feedback from the UE to the base station. Consequently, for example, it is possible for the UE to notify the base station of a lot of information. As another example, MAC signaling may be used. Consequently, for example, it is possible for the UE to promptly perform the notification to the base station. As another example, L1/L2 signaling may be used. Consequently, for example, it is possible for the UE to more promptly perform the notification to the base station.

The base station may notify the UE of a configuration for the feedback. The configuration may include, for example, information about a learning device to which the feedback is performed, information about a condition of the feedback, or information about the content of the feedback. For the notification of the information, RRC signaling, for example, RRCReconfiguration may be used, or MAC signaling or L1/L2 signaling may be used. The UE may perform the feedback to the base station by using the information.

As another example pertaining to the feedback from the UE to the base station, a relearning request from the UE to the base station may be made. The relearning request may be made by the AMF or the LMF.

The UE may make the relearning request to the base station periodically or as triggered by a predetermined condition. The period and/or the predetermined condition may be determined in a standard, or may be determined by the base station and the base station may notify the UE thereof. For example, the base station may notify the UE of a threshold as the predetermined condition.

For example, in the above case where the scheduling after the transmission of the CSI report does not meet the expectations of the UE, the predetermined condition may be a condition on the number of times the beam control has failed and/or the number of times the positioning has failed. Each number of times may be, for example, the total number of times or the number of times within a predetermined period.

For example, RRC signaling may be used for the relearning request from the UE to the base station. Consequently, for example, it is possible for the UE to notify the base station of a lot of information. As another example, MAC signaling may be used. Consequently, for example, it is possible for the UE to promptly perform the notification to the base station. As another example, L1/L2 signaling may be used. Consequently, for example, it is possible for the UE to more promptly perform the notification to the base station.

According to the fourth embodiment, the feedback on the learning model can be performed in the communication system, the relearning request to the base station can be made, and as a result, it is possible to prevent reliability in the communication system from reducing.

In the present disclosure, the model generation unit 812 of the learning device 810 may learn the encoding model and the decoding model in accordance with learning data created for a plurality of communication system devices, for example, UEs. Note that the model generation unit 812 may acquire learning data from UEs used in the same area, or may learn the encoding model and the decoding model by using learning data collected from a plurality of UEs that independently operate in different areas. In addition, it is also possible to add, in the middle of the learning, a communication system device as a target from which the learning data is collected, or to exclude the communication system device from such targets. Furthermore, an encoding model and/or a decoding model that has been learned for a certain communication system device may be applied to another communication system device, and the encoding model and the decoding model may be relearned for the other communication system device and updated.

The present disclosure may be applied to sidelink communication in which UEs directly communicate with each other not via a base station. Note that the sidelink communication is also referred to as terminal-to-terminal communication. For example, encoding/decoding of the CSI report may be applied to terminal-to-terminal communication. Consequently, for example, it is possible to improve usage efficiency of communication resources in the sidelink communication.

The present disclosure may be applied to IAB. For example, encoding/decoding of the CSI report may be applied to communication between an IAB-donor DU and an IAB-node, or communication between IAB-nodes. Consequently, for example, it is possible to improve usage efficiency of communication resources in a communication using IAB.

A statement of "gNB or cell" in the present disclosure means that it may either be a gNB or a cell unless otherwise specified.

The above-described embodiments and modifications thereof are merely examples, and the embodiments and modifications thereof can be freely combined. In addition, any component of the embodiments and modifications thereof can be appropriately changed or omitted.

For example, in the above-described embodiments and modifications thereof, the subframe is an example of a time unit of communication in the fifth generation communication system. The subframe may be a scheduling unit. In the above-described embodiments and modifications thereof, the processes described as those performed on a per subframe basis may be performed on a per TTI basis, on a per slot basis, on a per subslot basis, or on a per mini-slot basis.

For example, the methods disclosed in the above-described embodiments and modifications thereof may be applied not only to a vehicle-to-everything (V2X) service but also to a service using the SL communication. For example, the methods may be applied to the SL communication used in various services such as proximity-based service, public safety, communication between wearable terminals, and device-to-device communication in a factory.

While the present disclosure has been described in detail, the above description is in all aspects illustrative and not restrictive. It is understood that numerous modifications not illustrated can be devised.

### Reference Signs List

200, 210 communication system; 202 communication terminal device (user equipment); 203, 207, 213, 217, 223-1, 224-1, 224-2, 226-1, 226-2, 750 base station device (base station); 204 MME/S-GW unit (MME unit); 204a MME; 214 AMF/SMF/UPF unit (5GC unit); 218 central unit; 219 distributed unit; 301, 403 protocol processing unit; 302 application unit; 303, 404 transmission data buffer unit; 304, 405 encoder unit; 305, 406 modulation unit; 306, 407 frequency conversion unit; 307-1 to 307-4, 408-1 to 408-4 antenna; 308, 409 demodulation unit; 309, 410 decoder unit; 310, 411, 506, 526 control unit; 401 EPC communication unit; 402 other-base-station communication unit; 412 5GC communication unit; 501 PDN GW communication unit; 502, 522 base station communication unit; 503, 523 user plane communication unit; 504 HeNBGW communication unit; 505, 525 control plane control unit; 505-1, 525-1 NAS security unit; 505-2 SAE bearer control unit; 505-3, 525-3 idle state mobility management unit; 521 data network communication unit; 525-2 PDU session control unit; 527 session management unit; 751-1 to 751-8 beam; 810 learning device; 811, 831, 861 data acquisition unit; 812 model generation unit; 820, 850 learned model storage unit; 830 inference device (encoding device); 832 encoding unit; 840 transmission unit; 860 inference device (decoding device); 862 decoding unit; 870 communication control unit.

## Claims

1. A communication system comprising:
a communication terminal to encode transmission data by using an encoding model that encodes and outputs data that has been input; and
a base station to decode data encoded with the encoding model by using a decoding model that, when encoded data is input, decodes and outputs the data, wherein
the encoding model performs encoding on channel state-related data that is data on a channel state between the communication terminal and the base station, and
the base station executes machine learning using learning data including the channel state-related data in an un-encoded state to generate the encoding model and the decoding model, and notifies the communication terminal of a learning result of the encoding model.

2. The communication system according to claim 1, wherein
the communication terminal transmits the channel state-related data to the base station without encoding the channel state-related data during a period from when the base station performs a notification that the machine learning is started to when the machine learning is ended.

3. The communication system according to claim 1 or 2, wherein
when the communication terminal receives a notification of a learning result of the encoding model from the base station, the communication terminal constructs the encoding model on a basis of the learning result.

4. The communication system according to claim 3, wherein
when the communication terminal receives an instruction to start encoding of the channel state-related data from the base station after completing construction of the encoding model, the communication terminal starts encoding of the channel state-related data using the encoding model.

5. The communication system according to claim 3, wherein
when completing construction of the encoding model, the communication terminal starts encoding of the channel state-related data using the encoding model.

6. The communication system according to any one of claims 1 to 5, wherein
when a predetermined relearning condition is satisfied, the communication terminal requests the base station to execute relearning, and
the base station executes relearning of the encoding model and the decoding model.

7. The communication system according to claim 6, wherein
the base station
instructs the communication terminal to stop encoding of the channel state-related data in a case of starting relearning of the encoding model and the decoding model, and
notifies the communication terminal of a relearning result of the encoding model and instructs the communication terminal to start encoding of the channel state-related data in a case of ending relearning of the encoding model and the decoding model.

8. The communication system according to any one of claims 1 to 7, wherein
the base station notifies the communication terminal of information about data required to be included in the learning data, and
the communication terminal transmits, as the learning data, data that the base station has notified the communication terminal of.

9. The communication system according to any one of claims 1 to 8, wherein
when the communication terminal receives a notification of a learning result of the encoding model from the base station, the communication terminal notifies the base station of a confirmation result of the learning result, and
the base station determines whether relearning of the encoding model and the decoding model is required on a basis of the confirmation result that the communication terminal has notified the base station of.

10. The communication system according to any one of claims 1 to 9, wherein
in a case where a plurality of the communication terminals are connected to the base station,
the base station individually performs machine learning for each of the plurality of the communication terminals and uses a different encoding model and a different decoding model in communication with each of the plurality of the communication terminals.

11. The communication system according to any one of claims 1 to 9, wherein
in a case where a plurality of the communication terminals are connected to the base station,
the base station performs machine learning on some or all of the plurality of the communication terminals and uses a common encoding model and a common decoding model in communication with each of the plurality of the communication terminals.

12. A communication system comprising:
a first communication terminal to encode transmission data by using an encoding model that encodes and outputs data that has been input;
a second communication terminal unable to perform encoding of transmission data using the encoding model; and
a base station to decode data encoded with the encoding model of the first communication terminal by using a decoding model that, when encoded data is input, decodes and outputs the data, wherein
the encoding model performs encoding on channel state-related data that is data on a channel state between the first communication terminal and the base station, and
the base station executes machine learning using learning data to generate the encoding model and the decoding model, the learning data including the channel state-related data in an un-encoded state transmitted by the first communication terminal without performing encoding using the encoding model, and notifies the first communication terminal of a learning result of the encoding model.

13. The communication system according to claim 12, wherein
the first communication terminal and the second communication terminal each have a function of notifying the base station of information about availability of the encoding model.

14. The communication system according to claim 12 or 13, wherein
the first communication terminal has a function of notifying the base station of information on an encoding model usable by the first communication terminal.

15. The communication system according to any one of claims 12 to 14, comprising:
a plurality of the first communication terminals, wherein
on a basis of information on a usable encoding model that each of the plurality of the first communication terminals has notified the base station of, the base station individually determines, for each of the plurality of the first communication terminals, an encoding model and a decoding model to be used between each of the plurality of the first communication terminals and the base station.
